(19) Europäisches Patentamt
European Patent Office
Office européen des brevets

(11) **EP 4 672 296 A2**

(12) **EUROPEAN PATENT APPLICATION**

(43) Date of publication:
**31.12.2025 Bulletin 2026/01**

(21) Application number: 25178376.7

(22) Date of filing: **22.05.2025**

(51) International Patent Classification (IPC):
**H01J 37/02** *(2006.01)*    **H01J 37/28** *(2006.01)*

(52) Cooperative Patent Classification (CPC):
**H01J 37/026; H01J 37/28;** H01J 2237/221

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **04.06.2024 US 202418732999**

(71) Applicant: **FEI Company
Hillsboro, OR 97124-5793 (US)**

(72) Inventors:
- **POLOUCEK, Pavel
  Hillsboro, 97124 - 5793 (US)**
- **FICEK, Dominik
  Hillsboro, 97124 - 5793 (US)**

(74) Representative: **Boult Wade Tennant LLP
Salisbury Square House
8 Salisbury Square
London EC4Y 8AP (GB)**

(54) **CHARGING ARTIFACT MITIGATION VIA SCANNING DIRECTION ROTATION**

(57)    Systems/techniques are provided for facilitating charging artifact mitigation via scanning direction rotation. In various embodiments, a system can access a charged-particle microscope that is loaded with a specimen. In various aspects, the system can generate an aggregated image of the specimen, based on a plurality of images of the specimen that are captured by the charged-particle microscope according to a target scanning direction and a plurality of rotated scanning directions. In some instances, the plurality of rotated scanning directions and the target scanning direction can be uniformly distributed within a 360-degree range. In various cases, the specimen can charge non-homogeneously during scanning, each of the plurality of images can exhibit respective charging artifacts, and the aggregated image can exhibit no or reduced charging artifacts.

**EP 4 672 296 A2**

## Description

CROSS-REFERENCE TO RELATED APPLICATIONS

This application claims the benefit of the filing date of US Non-Provisional Application S/N 18/732,999 filed on June 4, 2024, the disclosure of which is incorporated herein by reference in its entirety.

BACKGROUND

Some specimens can be prone to charging artifacts when imaged by a charged-particle microscope. Charging artifacts can be undesirable.

SUMMARY

The following presents a summary to provide a basic understanding of one or more embodiments. This summary is not intended to identify key or critical elements, or delineate any scope of the particular embodiments or any scope of the claims. Its sole purpose is to present concepts in a simplified form as a prelude to the more detailed description that is presented later. In one or more embodiments described herein, devices, systems, computer-implemented methods, apparatus or computer program products that facilitate charging artifact mitigation via scanning direction rotation are described.

According to one or more embodiments, a system is provided. The system can comprise a non-transitory computer-readable memory that can store computer-executable components. The system can further comprise a processor that can be operably coupled to the non-transitory computer-readable memory and that can execute the computer-executable components stored in the non-transitory computer-readable memory. In various embodiments, the computer-executable components can comprise an access component that can access a charged-particle microscope that is loaded with a specimen. In various aspects, the computer-executable components can further comprise an aggregation component that can generate an aggregated image of the specimen, based on a plurality of images of the specimen that are captured by the charged-particle microscope according to a target scanning direction and a plurality of rotated scanning directions.

According to one or more embodiments, a computer-implemented method is provided. In various embodiments, the computer-implemented method can comprise accessing, by a device operatively coupled to a processor, a charged-particle microscope that is loaded with a specimen. In various aspects, the computer-implemented method can comprise generating, by the device, an aggregated image of the specimen, based on a plurality of images of the specimen that are captured by the charged-particle microscope according to a target scanning direction and a plurality of rotated scanning directions.

According to one or more embodiments, a computer program product for facilitating charging artifact mitigation via scanning direction rotation is provided. In various embodiments, the computer program product can comprise a non-transitory computer-readable memory having program instructions embodied therewith. In various aspects, the program instructions can be executable by a processor to cause the processor to access a scanning electron microscope that is loaded with a specimen. In various instances, the program instructions can be further executable to cause the processor to cause the scanning electron microscope to respectively capture a plurality of images of the specimen according to a target scanning direction and a plurality of rotated scanning directions, wherein the plurality of images exhibit respective charging artifacts. In various cases, the program instructions can be further executable to cause the processor to correctively-rotate those of the plurality of images that are captured according to the plurality of rotated scanning directions, such that the plurality of images are aligned with the target scanning direction. In various aspects, the program instructions can be further executable to cause the processor to average, after corrective-rotation, the plurality of images, thereby yielding an aggregated image of the specimen, wherein a visibility of charging artifacts in the aggregated image can be lesser than respective visibilities of charging artifacts in the plurality of images.

DESCRIPTION OF THE DRAWINGS

Various embodiments will be readily understood by the following detailed description in conjunction with the accompanying figures. To facilitate this description, like reference numerals designate like structural elements. Embodiments are illustrated by way of example, not by way of limitation, in the figures. The figures are not necessarily drawn to scale.

FIG. 1 illustrates an example, non-limiting block diagram of a scientific instrument module in accordance with various embodiments described herein.
FIG. 2 illustrates an example, non-limiting flow diagram of a computer-implemented method in accordance with various embodiments described herein.
FIG. 3 illustrates a block diagram of an example, non-limiting system that facilitates charging artifact mitigation via scanning direction rotation in accordance with one or more embodiments described herein.
FIG. 4 illustrates a block diagram of an example, non-limiting system including a plurality of rotated scanning directions and a plurality of captured images that facilitates charging artifact mitigation via scanning direction rotation in accordance with one or more embodiments described herein.
FIGs. 5-8 illustrate example, non-limiting block diagrams showing how a plurality of rotated scanning directions can be implemented to capture a plurality of images in accordance with one or more embodiments described herein.

FIG. 9 illustrates a block diagram of an example, non-limiting system including plurality of first edited images that facilitates charging artifact mitigation via scanning direction rotation in accordance with one or more embodiments described herein.

FIGs. 10-12 illustrate example, non-limiting block diagrams showing how a plurality of first edited images can be obtained in accordance with one or more embodiments described herein.

FIG. 13 illustrates a block diagram of an example, non-limiting system including a plurality of second edited images that facilitates charging artifact mitigation via scanning direction rotation in accordance with one or more embodiments described herein.

FIGs. 14-16 illustrate example, non-limiting block diagrams showing how a plurality of second edited images can be obtained in accordance with one or more embodiments described herein.

FIG. 17 illustrates a block diagram of an example, non-limiting system including an aggregated image that facilitates charging artifact mitigation via scanning direction rotation in accordance with one or more embodiments described herein.

FIG. 18 illustrates an example, non-limiting block diagram showing how an aggregated image can be obtained in accordance with one or more embodiments described herein.

FIGs. 19-20 illustrate example, non-limiting experimental results in accordance with one or more embodiments described herein.

FIG. 21 illustrates an example, non-limiting block diagram of a graphical user interface that can be used in the performance of some or all of the methods or techniques disclosed herein, in accordance with various embodiments described herein.

FIG. 22 illustrates an example, non-limiting block diagram of a computing device that can perform some or all of the methods or techniques disclosed herein, in accordance with various embodiments described herein.

FIG. 23 illustrates an example, non-limiting block diagram of a scientific instrument support system in which some or all of the methods or techniques disclosed herein may be performed, in accordance with various embodiments described herein.

FIG. 24 illustrates a block diagram of an example, non-limiting operating environment in which one or more embodiments described herein can be facilitated.

FIG. 25 illustrates an example networking environment operable to execute various implementations described herein.

FIG. 26 illustrates an example dual beam microscope that can be implemented in accordance with various embodiments described herein.

DETAILED DESCRIPTION

The following detailed description is merely illustrative and is not intended to limit embodiments or application/uses of embodiments. Furthermore, there is no intention to be bound by any expressed or implied information presented in the preceding Background or Summary sections, or in the Detailed Description section.

One or more embodiments are now described with reference to the drawings, wherein like referenced numerals are used to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

Various operations can be described as multiple discrete actions or operations in turn, in a manner that is most helpful in understanding the subject matter disclosed herein. However, the order of description should not be construed as to imply that these operations are necessarily order dependent. In particular, these operations can be performed in an order different from the order of presentation. Operations described can be performed in a different order from the described embodiments. Various additional operations can be performed, or described operations can be omitted in additional embodiments.

Although some elements may be referred to in the singular (e.g., "a processing device"), any appropriate elements may be represented by multiple instances of that element, and vice versa. For example, a set of operations described as performed by a processing device may be implemented with different ones of the operations performed by different processing devices. As used herein, the phrase "based on" should be understood to mean "based at least in part on," unless otherwise specified.

A charged-particle microscope (e.g., a scanning electron microscope (SEM), a dual beam microscope) can be any suitable computerized device that can capture or generate microscopic or nanoscopic images of specimens in a scientific, laboratory, research, or clinical operational environment. To facilitate the capture or generation of such images, charged-particle microscopes can leverage complex arrangements of actuatable parts (e.g., ion sources, electron sources, optical lenses or apertures, optical plates or deflectors, columns, coils, heaters, coolers, fluid valves, fluid pumps, circuit switches, specimen stages), sensors (e.g., ion detectors, electron detectors, voltmeters, thermistors, potentiometers, pressure gauges), or consumables (e.g., carrier fluids, calibrants, filters, reactive gases).

Some specimens can be prone to the formation of charging artifacts when imaged by a charged-particle microscope. In particular, when a charged-particle microscope scans a specimen that is nonconductive or otherwise poorly conductive (e.g., a ceramic specimen), the specimen can become heterogeneously or non-uniformly charged. Such heterogeneous or non-uniform charging can be visually manifested as conspicuous or otherwise highly noticeable streaks (e.g., light or dark streaking shadows, bars, scratches, or other distortions) in whatever scanned image of the specimen that the charged-particle microscope captures or generates. Such streaks can be referred to as charging artifacts.

Charging artifacts can be undesirable. After all, charging artifacts can obscure the specimen as depicted in the scanned image, such that whatever downstream analyses (e.g., image classification, image segmentation, image regression) that are planned or desired to be performed on the scanned image cannot be confidently or reliably performed. In some cases, a scanned image that contains severe charging artifacts can be considered as corrupted, tainted, marred, or otherwise not usable.

There are various existing techniques that attempt to mitigate or eliminate charging artifacts. Some of such existing techniques require the implementation of niche microscope hardware, such as charge neutralizers or conductive specimen coaters. Others of such existing techniques involve specimen-tailored tuning of microscope parameters, such as specimen-tailored tuning of scan speed, beam voltage, or detector settings. Unfortunately, such existing techniques suffer from significantly restricted generalizability. Indeed, many (if not most) charged-particle microscopes that are deployed in the field lack or otherwise are not equipped with the niche hardware that some existing techniques rely upon to attenuate charging artifacts. Furthermore, there are a myriad of different types or compositions of specimens that are prone to charging artifacts. Thus, existing techniques that rely upon microscope parameter tuning involve time-consuming or effort-intensive tweaking or experimentation in order to identify what specific microscope parameter values (e.g. what specific scan speed, what specific beam voltage, what specific detector settings) should be used for any given specimen. In other words, different specimens can have different compositions and thus can require different microscope parameter values to avoid or reduce charging artifacts (e.g., a first microscope parameter configuration might reduce charging artifacts for one type of specimen but not for another type of specimen). Thus, existing techniques cannot easily or readily be implemented across different types of charged-particle microscopes or across different types of specimens. This severe lack of generalizability of existing techniques can be considered as disadvantageous.

Accordingly, systems or techniques that can mitigate or eliminate charging artifacts in a generalizable fashion can be desirable.

Various embodiments described herein can address this technical problem. One or more embodiments described herein can include systems, computer-implemented methods, apparatus, or computer program products that can facilitate charging artifact mitigation via scanning direction rotation. In other words, the inventors of various embodiments described herein realized that charging artifacts can depend upon scanning direction (e.g., realized that charging artifacts can be anisotropic) and thus can be ameliorated by rotating or otherwise manipulating the scanning direction of a charged-particle microscope. In particular, when a charged-particle microscope captures an image by scanning a specimen, the charging artifacts (e.g., conspicuous light or dark streaks) in the image can be oriented along or otherwise substantially parallel to whichever scanning direction that the charged-particle microscope implements for that scan. Various embodiments described herein can involve performing multiple scans of the specimen along different scanning directions that are symmetrically rotated with respect to each other, thereby yielding multiple scanned images of the specimen. Various embodiments described herein can also involve aggregating or averaging those multiple scanned images together (after performance of corrective rotation or cropping), thereby yielding a single resulting image of the specimen. Since the multiple scanned images have different scanning directions, and since charging artifacts are anisotropic, those multiple scanned images can depict the specimen with differently oriented charging artifacts. In other words, portions of the specimen that are obscured or distorted by charging artifacts in some of those multiple images can be unobscured or undistorted in others of those multiple images. In still other words, scanning direction rotation can cause charging artifacts to be located at different positions in different ones of the multiple images. So, by aggregating or averaging those multiple images together, the charging artifacts can be considered as collectively dropping or cancelling out, such that the single resulting image depicts the specimen with no (or otherwise significantly less noticeable) charging artifacts. Note that such mitigation or elimination of charging artifacts can be facilitated, regardless of specimen type and regardless of microscope type. Accordingly, various embodiments described herein can be considered as significantly more generalizable than existing techniques.

Various embodiments described herein can be considered as a computerized tool (e.g., any suitable combination of computer-executable hardware or computer-executable software) that can facilitate charging artifact mitigation via scanning direction rotation. In various aspects, such computerized tool can comprise an access component, a scanning component, an alignment component, a crop component, or an aggregation component.

In various embodiments, there can be a charged-particle microscope. In various aspects, the charged-particle microscope can exhibit any suitable design or construction (e.g., can be an SEM, can be a dual-beam microscope). In various instances, there can be any suitable specimen (e.g., semiconductor wafer or lamella) that is loaded in the charged-particle microscope (e.g., that is currently located or positioned on an actuatable stage of the charged-particle microscope). In various cases, the charged-particle microscope can have a selectively adjustable setting or parameter that controls a scanning direction of the charged-particle microscope (e.g., that controls which axis the charged-particle microscope uses to raster-scan the specimen). In various instances, the charged-particle microscope can have a 360-degree range from which to choose or select a scanning direction.

In various aspects, it can be desired to obtain a scanned image of the specimen via the charged-particle microscope and according to or otherwise in alignment with any suitable target scanning direction (e.g., any scanning direction from the 360-degree range of possible scanning directions). However, in various instances, the specimen can have a physical or chemical composition that is likely to yield charging artifacts (e.g., the specimen can be ceramic), which can be undesirable. As described herein, the computerized tool can generate an image of the specimen that is in alignment with the target scanning direction and that exhibits few or no charging artifacts.

In various embodiments, the access component of the computerized tool can electronically access the charged-particle microscope. For instance, the access component can electronically interface or communicate with (e.g., send electronic commands to, read electronic signals from) the charged-particle microscope. In some cases, the access component can be considered as a conduit through which other components of the computerized tool can electronically interact with (e.g., read, write, edit, copy, manipulate, execute, activate, deactivate) the charged-particle microscope.

In various embodiments, the scanning component of the computerized tool can electronically cause the charged-particle microscope to capture a plurality of images of the specimen, according to the target scanning direction and according to a plurality of rotated scanning directions.

More specifically, the scanning component can electronically instruct the charged-particle microscope to perform a scan on the specimen using the target scanning direction. Non-scanning-direction parameters (e.g., scan speed, beam voltage, focal spot size, detector settings, field of view size) of the charged-particle microscope can be set to any suitable values, states, or configurations during such scan. In any case, such scan can cause the charged-particle microscope to produce or capture a target image of the specimen. In various aspects, the target image can be a pixel array or voxel array that depicts the specimen (e.g., that illustrates surface details or interior details of the specimen). In various instances, whatever field of view the charged-particle microscope utilizes during such scan can be referred to as a target field of view. In various cases, the physical or chemical composition of the specimen can cause the target image to be tainted or marred with charging artifacts that are oriented along the target scanning direction.

Now, the plurality of rotated scanning directions can comprise any suitable number of rotated scanning directions. In various aspects, a rotated scanning direction can be any suitable scanning direction that is implementable by the charged-particle microscope (e.g., that is chosen or selected from the 360-degree range of possible scanning directions) and that is rotated about a center or centroid of the target field of view by a respective or unique angular distance from the target scanning direction. Equivalently, each rotated scanning direction can be obtained by rotating the target scanning direction about the center or centroid of the target field of view by a respective or unique angular displacement. In some instances, the target scanning direction and the plurality of rotated scanning directions can collectively be radially-symmetric with respect to each other. In other words, the target scanning direction and the plurality of rotated scanning directions can together span 360 degrees of rotation via evenly-spaced angular increments. In still other words, the target scanning direction and the plurality of rotated scanning directions can be considered as being uniformly distributed throughout a 360-degree range of the charged-particle microscope.

As a non-limiting example, suppose that the plurality of rotated scanning directions comprises seven directions. If the target scanning direction and those seven rotated directions are radially-symmetric or uniformly distributed, then the target scanning direction and those seven rotated directions can be evenly-spaced by 45-degree increments: a first rotated scanning direction can be located 45 degrees clockwise from the target scanning direction; a second rotated scanning direction can be located 45-degrees clockwise from the first rotated scanning direction, which is 90 degrees clockwise from the target scanning direction; a third rotated scanning direction can be located 45-degrees clockwise from the second rotated scanning direction, which is 135 degrees clockwise from the target scanning direction; a fourth rotated scanning direction can be located 45-degrees clockwise from the third rotated scanning direction, which is 180 degrees clockwise from the target scanning direction; a fifth rotated scanning direction can be located 45-degrees clockwise from the fourth rotated scanning direction, which is 225 degrees clockwise from the target scanning direction; a sixth rotated scanning direction can be located 45-degrees clockwise from the fifth rotated scanning direction, which is 270 degrees clockwise from the target scanning direction; and a seventh rotated scanning direction can be located 45-degrees clockwise from the sixth rotated scanning direction, which is 315 degrees clockwise from the target scanning direction.

As another non-limiting example, suppose that the plurality of rotated scanning directions comprises eleven directions. If the target scanning direction and those eleven rotated directions are radially-symmetric or uniformly distributed, then the target scanning direction and those eleven rotated directions can be evenly-spaced by 30-degree increments: a first rotated scanning direction can be located 30 degrees clockwise from the target scanning direction; a second rotated scanning direction can be located 30-degrees clockwise from the first rotated scanning direction, which is 60 degrees clockwise from the target scanning direction; a third rotated scanning direction can be located 30-degrees clockwise from the second rotated scanning direction, which is 90 degrees clockwise from the target scanning direction; a fourth rotated scanning direction can be located 30-degrees clockwise from the third rotated scanning direction, which is 120 degrees clockwise from the target scanning direction; a fifth rotated scanning direction can be located 30-degrees clockwise from the fourth rotated scanning direction, which is 150 degrees clockwise from the target scanning direction; a sixth rotated scanning direction can be located 30-degrees clockwise from the fifth rotated scanning direction, which is 180 degrees clockwise from the target scanning direction; a seventh rotated scanning direction can be located 30-degrees clockwise from the sixth rotated scanning direction, which is 210 degrees clockwise from the target scanning direction; an eighth rotated scanning direction can be located 30-degrees clockwise from the seventh rotated scanning direction, which is 240 degrees clockwise from the target scanning direction; a ninth rotated scanning direction can be located 30-degrees clockwise from the eighth rotated scanning direction, which is 270 degrees clockwise from the target scanning direction; a tenth rotated scanning direction can be located 30-degrees clockwise from the ninth rotated scanning direction, which is 300 degrees clockwise from the target scanning direction; and an eleventh rotated scanning direction can be located 30-degrees clockwise from the tenth rotated scanning direction, which is 330 degrees clockwise from the target scanning direction.

However, these are mere non-limiting examples. In other aspects, the target scanning direction and the plurality of rotated scanning directions can be not radially-symmetric with respect to each other. In other words, the target scanning direction and the plurality of rotated scanning directions can together span 360 degrees of rotation (or even less than 360 degrees of rotation) via unevenly-spaced angular increments. In still other words, the target scanning direction and the plurality of rotated scanning directions can be non-uniformly distributed throughout a 360-degree range of the charged-particle microscope.

In any case, the scanning component can electronically instruct the charged-particle microscope to perform a respective scan on the specimen using each of the plurality of rotated scanning directions. This can yield a plurality of rotated images, each of which can be a pixel array or voxel array that depicts the specimen from a unique or distinct rotated perspective. In various aspects, whatever non-scanning-direction parameter values or states (e.g., scan speed, beam voltage, focal spot size, detector settings) that the charged-particle microscope used to generate the target image can also be used to generate each of the plurality of rotated images, with the exception of field of view. In particular, each of the plurality of rotated scanning directions can have a respective field of view that is enlarged or otherwise resized so as to circumscribe the target field of view. Indeed, without such enlarging or resizing, some of the plurality of rotated images would cut-off or otherwise omit corners of the target field of view. Accordingly, because of such enlarging or resizing, the number of pixels or voxels in each of the plurality of rotated images can be greater than or equal to that of the target image, such that whatever visual content is depicted in the target image can also be depicted (from a rotated perspective or orientation but using a same spatial resolution) in each of the plurality of rotated images (e.g., no portions of the target image are cut-off in or omitted from any of the plurality of rotated images). In other words, some of the plurality of rotated images can be the same size (in terms of number or arrangement of pixels or voxels) as each other or as the target image, whereas others of the plurality of rotated images can be different sizes (in terms of number or arrangement of pixels or voxels) than each other or than the target image.

Note that, as above, the physical or chemical composition of the specimen can cause each of the plurality of rotated images to be tainted or marred with charging artifacts that are oriented along a respective one of the plurality of rotated scanning directions. Accordingly, for any two images selected from the superset containing the target image and the plurality of rotated images, the charging artifacts in those two selected images can obfuscate (e.g., can be located or placed over top of) different or otherwise non-identical portions of the specimen.

In various embodiments, the alignment component can leave the target image unchanged. However, the alignment component can electronically edit or otherwise manipulate the plurality of rotated images, such that their visual contents become aligned or registered with that of the target image. After such editing or manipulation, the plurality of rotated images can now be referred to as a plurality of aligned images. More specifically, for each given rotated image, the alignment component can correctively-rotate that given rotated image about the center or centroid of the target field of view by whatever angular displacement separates its respective scanning direction from the target scanning direction, thereby yielding a respective aligned image. Prior to such corrective rotation, whatever portions of the specimen that are depicted in the given rotated image can be shown at a same spatial resolution as, but from a different perspective or orientation than, depicted in the target image (e.g., the given rotated image might appear to be fully or partially upside-down or sideways with respect to the target image). However, after such corrective rotation, whatever portions of the specimen that are depicted in the given rotated image (now referred to as an aligned image) can be shown at the same spatial resolution and from the same perspective or orientation as depicted in the target image. In some cases, any other suitable image registration or alignment techniques can be implemented by the alignment component in conjunction with such corrective rotation, such as optical drift correction techniques. In any case, the plurality of aligned images can all show the specimen with the same spatial resolution and from the same perspective or orientation as the target image.

In various embodiments, the crop component of the computerized tool can leave the target image unchanged. However, the crop component can electronically edit or otherwise manipulate the plurality of aligned images, such that they now contain the same number or arrangement of pixels or voxels as the target image. After such editing or manipulation, the plurality of aligned images can be referred to as a plurality of cropped images. Indeed, as mentioned above, the number of pixels or voxels in each of the plurality of rotated images, and thus in each of the plurality of aligned images, can be greater than or equal to that of the target image. In other words, various of the plurality of aligned images can have extraneous pixels or voxels that are not present in the target image (e.g., such pixels or voxels can depict visual content that is beyond or outside the target field of view). In various aspects, for each given aligned image, the crop component can remove, delete, or otherwise crop-out from the given aligned image whichever pixels or voxels that are not contained in the target image, thereby yielding a respective cropped image. Accordingly, each of the plurality of cropped images can depict or show the specimen using the same spatial resolution and from the same perspective or orientation as the target image, and that respective cropped image can also be of the same size (in terms of number or arrangement of pixels or voxels) as the target image.

Now, in various embodiments, the aggregation component of the computerized tool can electronically generate an aggregated image, based on the plurality of cropped images. More specifically, since each of the plurality of cropped images can be the same size (in terms of number or arrangement of pixels or voxels) as the target image, the aggregation component can average together (e.g., via pixel-wise or voxel-wise averaging) the target image and the plurality of cropped images. In various aspects, the computational result of such averaging can be referred to as the aggregated image. In various instances, the aggregated image can be the same size (in terms of number or arrangement of pixels or voxels) as the target image. Furthermore, the aggregated image can depict the specimen using the same spatial resolution and from the same perspective or orientation as the target image. However, unlike the target image, the aggregated image can contain no (or can otherwise contain significantly fewer or significantly less conspicuous versions of) charging artifacts. Indeed, as mentioned above, each of the plurality of rotated images, and thus each of the plurality of cropped images, can have uniquely-positioned, uniquely-located, or otherwise uniquely-spatially-distributed charging artifacts (e.g., the charging artifacts in any given cropped image can be oriented in parallel to whatever rotated scanning direction from which that given cropped image was derived). So, during the averaging computation, the various charging artifacts that are collectively depicted in the target image and the plurality of cropped images can refrain from constructively interfering with each other. In other words, each unique or distinct charging artifact can be shown in only one (or an otherwise small proportion) of the superset containing the target image and the plurality of cropped images, and so each unique or distinct charging artifact can be considered as having or carrying very little weight in or during the averaging computation. Accordingly, all the various charging artifacts can be considered as dropping out, cancelling out, or otherwise being severely reduced during the averaging computation. In contrast, the various features or portions of the specimen can be depicted in the same locations or positions across all of the superset containing the target image and the plurality of cropped images, and so the features or portions of the specimen can be considered as having or carrying significant weight in or during the averaging computation. Thus, although the charging artifacts can drop out or otherwise be reduced by averaging, the features or portions of the specimen can be preserved or otherwise reinforced by averaging.

In this way, various embodiments described herein can enable the charged-particle microscope to capture or generate an image of the specimen according to the target scanning direction, where such image contains no (or, at most, significantly inconspicuous or unnoticeable) charging artifacts. Note that such embodiments can be applied even if the charged-particle microscope lacks charge neutralizers, conductive specimen coaters, or other niche equipment specially designed to mitigate charging artifacts. Also, note that such embodiments can be applied to the specimen, regardless of the physical or chemical composition of the specimen. Therefore, various embodiments described herein can be considered as a highly generalizable or universal technique for mitigating or attenuating charging artifacts (e.g., can be applied across all charged-particle microscopes and all specimens).

Various embodiments described herein can be employed to use hardware or software to solve problems that are highly technical in nature (e.g., to facilitate charging artifact mitigation via scanning direction rotation), that are not abstract and that cannot be performed as a set of mental acts by a human. Further, some of the processes performed can be performed by a specialized computer (e.g., electron microscopes such as SEMs or dual-beam microscopes) for carrying out defined acts related to the field of charged-particle microscopy.

For example, such defined acts can include: accessing, by a device operatively coupled to a processor, a charged-particle microscope that is loaded with a specimen; and generating, by the device, an aggregated image of the specimen, based on a plurality of images of the specimen that are captured by the charged-particle microscope according to a target scanning direction and a plurality of rotated scanning directions. In various aspects, the plurality of rotated scanning directions and the target scanning direction can be uniformly distributed within a 360-degree range. In various instances, a target image of the plurality of images can be captured according to the target scanning direction and can have a target field of view of the specimen, and remaining images of the plurality of images can have respectively resized fields of view that circumscribe the target field of view. In various cases, such defined acts can comprise: respectively correctively-rotating, by the device, the plurality of images according to the plurality of rotated scanning directions, thereby yielding a plurality of aligned images that are aligned with the target field of view; respectively applying, by the device, drift-correction to the plurality of aligned images; respectively cropping, by the device and out of the plurality of aligned images, any pixels or voxels that are not present in the target field of view, thereby yielding a plurality of cropped images each having the same size as the target image; and averaging, by the device, the plurality of cropped images and the target image together, thereby yielding the aggregated image. In various aspects, the specimen can charge non-homogeneously during scanning, each of the plurality of images can exhibit respective charging artifacts, and the aggregated image can exhibit no, or otherwise visually reduced, charging artifacts.

Such defined acts are inherently computerized. Indeed, a charged-particle microscope (e.g., SEM, dual beam microscope) is a highly-technical computerized device comprising specific computerized hardware (e.g., temperature sensors, pressure sensors, voltage sensors, ion beam emitters, electron beam emitters, focusing lenses, ion detectors, electron detectors, beam apertures, fluid valves, actuatable specimen stages). A charged-particle microscope and the operations that it performs cannot be implemented by the human mind, or by a human with pen and paper, in any reasonable or practicable way without computers. Furthermore, the herein-described image edits or manipulations (e.g., corrective rotations, registrations, cropping) are all inherently computerized actions that are performed on scanned images produced by a charged-particle microscope. Neither the human mind, nor a human with mere pen and paper, can rotate or crop the pixel arrays or voxel arrays that are generated by a charged-particle microscope. Further still, mitigation or reduction of charging artifacts is an inherently computerized task. Neither the human mind, nor a human with mere pen and paper, can mitigate or reduce the visibility of charging artifacts that are depicted in the pixel arrays or voxel arrays that are captured by a charged-particle microscope.

Moreover, various embodiments described herein can integrate into a practical application various teachings relating to the field of charged-particle microscopy. As explained above, charged-particle microscopes can generate or capture scanned images of specimens, and some specimens can charge non-uniformly so as to cause undesirable charging artifacts (e.g., streaks, shadows, other distortions) to afflict their resulting scanned images. Some existing techniques attempt to address charging artifacts by using niche or uncommon microscope hardware (e.g., charge neutralizers, conductive specimen coaters). Unfortunately, most charged-particle microscopes are not outfitted or equipped with such niche or uncommon hardware and thus cannot benefit from such existing techniques. Other existing techniques attempt to address charging artifacts by tuning operational parameters (e.g., scan speed, beam voltage, detector settings) to whatever specific values or states have been experimentally found to minimize charging artifacts for any given specimen. Unfortunately, such other existing techniques require significant experimentation or tinkering for each different type or composition of specimen. Accordingly, existing techniques can be considered as not being easily or readily generalizable or universal across different charged-particle microscopes or across different types of specimens.

Various embodiments described herein can help to ameliorate this problem, by implementing charging artifact mitigation via scanning direction rotation. When given a specimen, rather than capturing only a single image of that specimen, various embodiments described herein can instead capture a plurality of images of the specimen according to a respectively corresponding plurality of rotated scanning directions. Indeed, charging artifacts can be anisotropic, such that they are physically oriented along or in parallel to whatever scanning direction is used. So, each of the plurality of images can depict the specimen according to a distinct or unique scanning direction and can accordingly have distinct or unique charging artifacts that are not identically positioned to the charging artifacts of any others of the plurality of images. In various aspects, various embodiments described herein can respectively edit (e.g., via corrective rotations or cropping) the plurality of images, so that they all are the same size as each other and depict the specimen from the same perspective or orientation as each other. In various instances, various embodiments described herein can average together, after such editing, the plurality of images, thereby yielding an aggregated image. Unlike the plurality of images, the aggregated image can depict the specimen without (or otherwise with inconspicuous or less noticeable) charging artifacts. Indeed, because each of the plurality of images can be considered as having its own uniquely-located or uniquely-oriented charging artifacts, the act of averaging the plurality of images together can cause all of the charging artifacts to drop out or otherwise nearly disappear (e.g., each unique or distinct charging artifact can be present in only a small percentage of the plurality of images, so that each unique or distinct charging artifact can be considered as being low-weighted or nearly unweighted during averaging). In this way, charging artifacts can be reduced or eliminated, no matter what type of charged-particle microscope is implemented, and no matter what type of specimen is scanned. In other words, various embodiments described herein can be considered as a clever or innovative technique for reducing, mitigating, or attenuating charging artifacts that is applicable or generalizable across different charged-particle microscopes (unlike existing techniques that rely on niche microscope hardware) and across different specimens (unlike existing techniques that rely on specimen-tailored parameter optimization). For at least the above reasons, various embodiments described herein can be considered as addressing or ameliorating various problems or disadvantages that afflict existing techniques for mitigating charging artifacts. Therefore, various embodiments described herein can be considered as a concrete and tangible technical improvement in the field of charged-particle microscopy. Accordingly, various embodiments described herein certainly qualify as useful and practical applications of computers.

Furthermore, various embodiments described herein can control real-world tangible devices based on the disclosed teachings. For example, various embodiments described herein can electronically activate, deactivate, or otherwise actuate real-world hardware (e.g., ion beam emitters, ion focusing lenses, carrier fluid valves/pumps) of real-world charged-particle microscopes (e.g., SEMs, dual-beam microscopes).

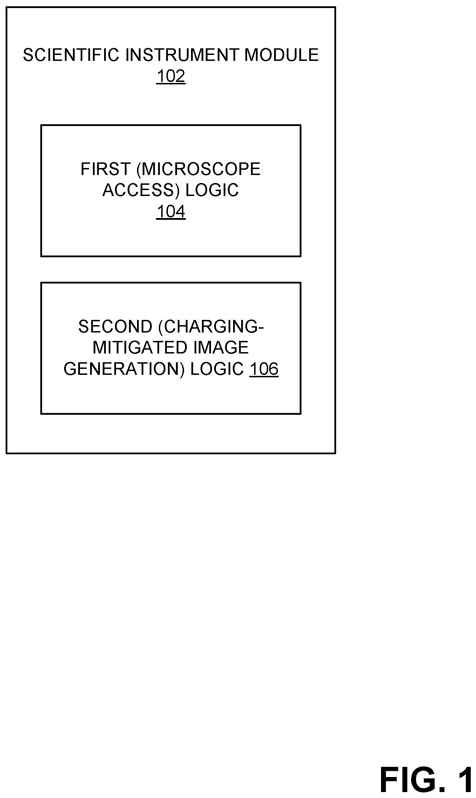

FIG. 1 illustrates an example, non-limiting block diagram of a scientific instrument module 102 in accordance with various embodiments described herein.

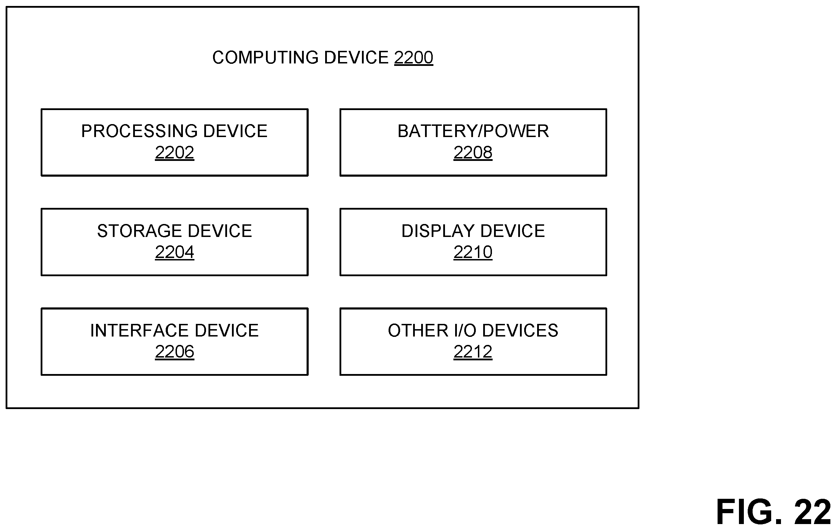

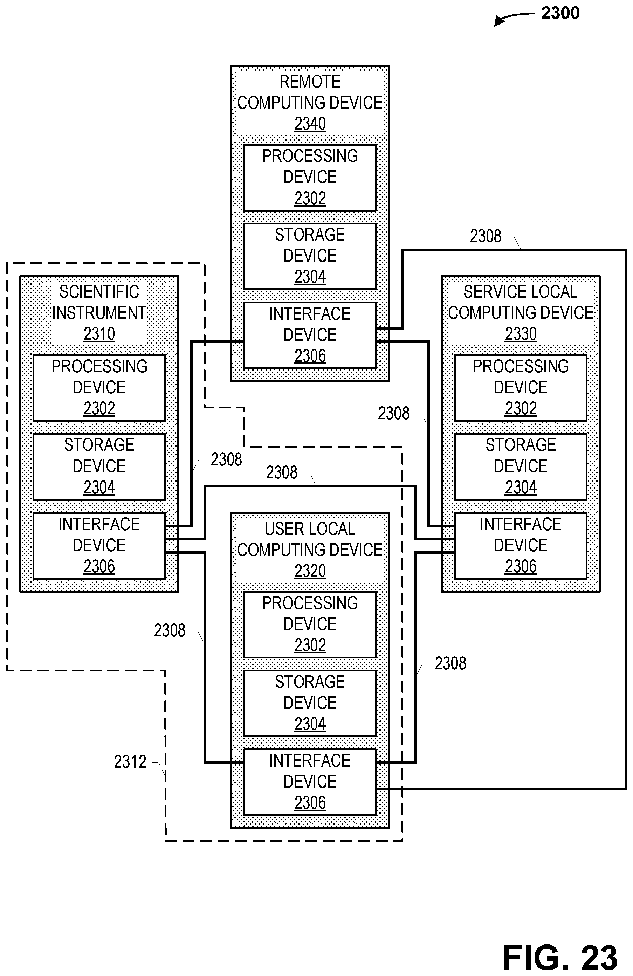

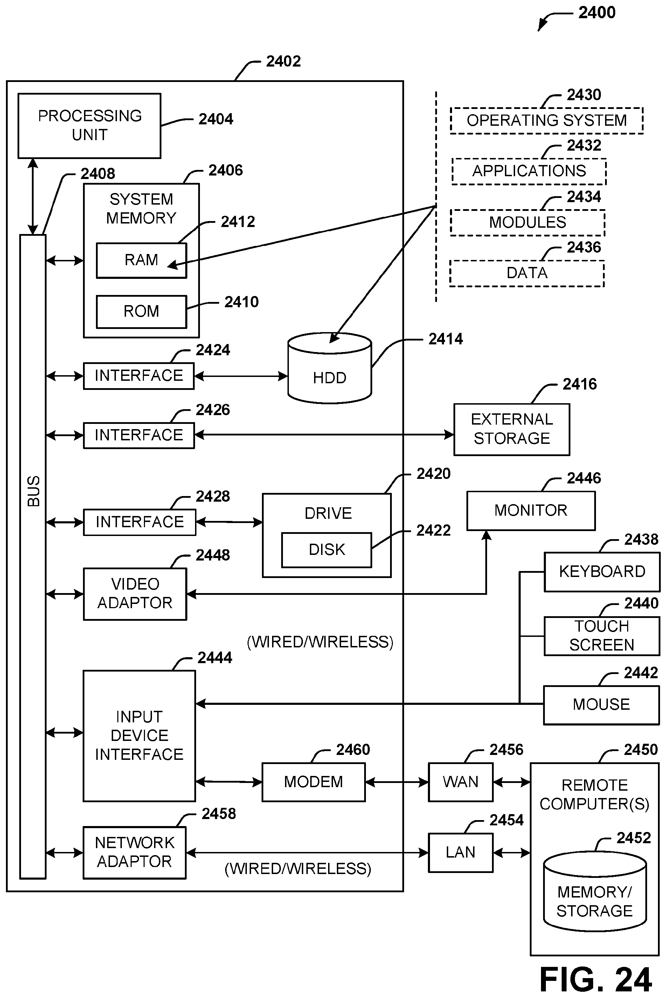

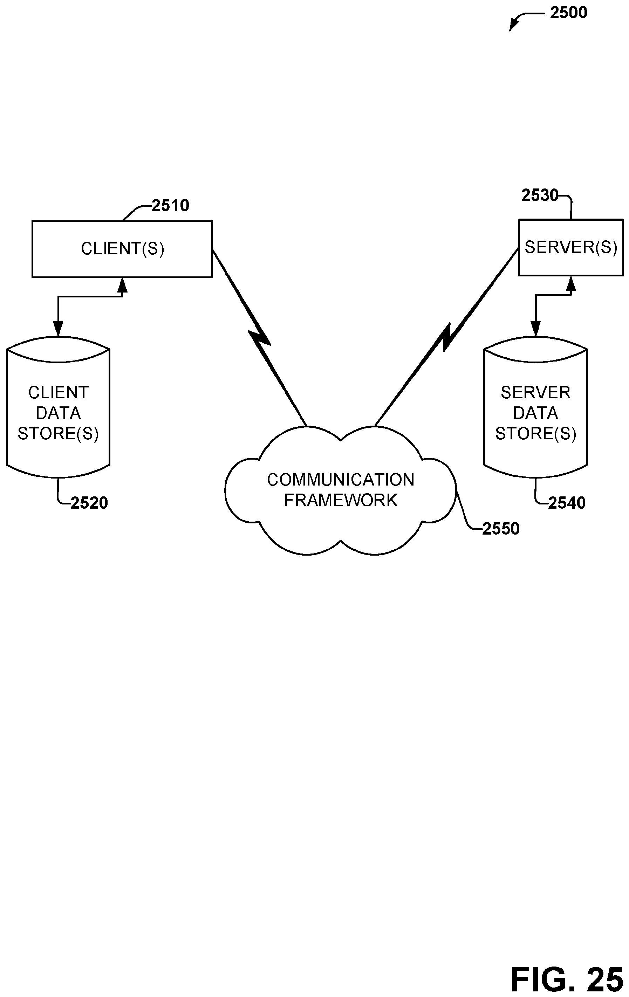

In various embodiments, the scientific instrument module 102 can be implemented by circuitry (e.g., including electrical or optical components), such as a programmed computing device. Logic of the scientific instrument module 102 can be included in a single computing device or can be distributed across multiple computing devices that are in communication with each other as appropriate. Examples of computing devices that may, singly or in combination, implement the scientific instrument module 102 are discussed herein with reference to FIGs. 22 and 24, and examples of systems or networks of interconnected computing devices, in which the scientific instrument module 102 may be implemented across one or more of the computing devices, are discussed herein with reference to FIGs. 23 and 25.

The scientific instrument module 102 can include first logic 104 and second logic 106. As used herein, the term "logic" can include an apparatus that is to perform a set of operations associated with the logic. For example, any of the logic elements included in the scientific instrument module 102 can be implemented by one or more computing devices programmed with instructions to cause one or more processing devices of the computing devices to perform the associated set of operations. In a particular embodiment, a logic element may include one or more non-transitory computer-readable media having instructions thereon that, when executed by one or more processing devices of one or more computing devices, cause the one or more computing devices to perform the associated set of operations. As used herein, the term "module" can refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module can omit one or more of the logic elements depicted in the associated drawings; for example, a module may include a subset of the logic elements depicted in the associated drawings when that module is to perform a subset of the operations discussed herein with reference to that module.

In various embodiments, there can be a scientific instrument corresponding to the scientific instrument module 102. In various aspects, the scientific instrument can be any suitable computerized device that can electronically measure some scientifically-relevant, clinically-relevant, or research-relevant characteristic, property, or attribute of an analytical specimen (e.g., of a known or unknown mixture, compound, or collection of matter). As a non-limiting example, a scientific instrument can be a scanning electron microscope. In such case, the scientific instrument can capture images of the analytical specimen, so as to measure or determine a surface topography, a surface material composition, or a crystallographic structure of the analytical specimen. As another non-limiting example, a scientific instrument can be a dual beam microscope. In such case, the scientific instrument can capture images of the analytical specimen in addition to being able to mill the analytical specimen. As a more general non-limiting example, a scientific instrument can be any suitable type of charged-particle microscope (e.g., some types of microscopes can use beams of non-electron ions to capture images).

In various embodiments, the first logic 104 can access the charged-particle microscope, such that electronic data can be read from the charged-particle microscope, and such that electronic instructions can be transmitted to the charged-particle microscope. In various cases, the charged-particle microscope can be loaded with any suitable specimen.

In various embodiments, the second logic 106 can involve generating an aggregated image of the specimen, based on a plurality of images of the specimen that are captured by the charged-particle microscope according to a target scanning direction and a plurality of rotated scanning directions. More specifically, each of the plurality of rotated scanning directions can have some unique or respective angular displacement from the target scanning direction. In various aspects, the second logic 106 can involve instructing the charged-particle microscope to scan the specimen according to the target scanning direction, thereby yielding a target image. Moreover, the second logic 106 can include instructing the charged-particle microscope to scan the specimen according to each of the plurality of rotated scanning directions, thereby yielding a plurality of rotated images. In various instances, the second logic 106 can involve correctively-rotating the plurality of rotated images to be aligned or registered with the target image, thereby yielding a plurality of aligned images. In various cases, the second logic 106 can include cropping from each of the plurality of aligned images whichever pixels or voxels that are not present in the target image, thereby yielding a plurality of cropped images. In various aspects, the second logic 106 can involve averaging the target image and the plurality of cropped images together, thereby yielding the aggregated image. In various instances, the aggregated image can depict the specimen from the same perspective or orientation as the target image. However, the aggregated image can contain fewer or otherwise less noticeable charging artifacts as compared to the target image and as compared to each of the plurality of cropped images.

Accordingly, the scientific instrument module 102 can facilitate charging artifact mitigation via scanning direction rotation, no matter the type of charged-particle microscope, and no matter the physical or chemical composition of the specimen.

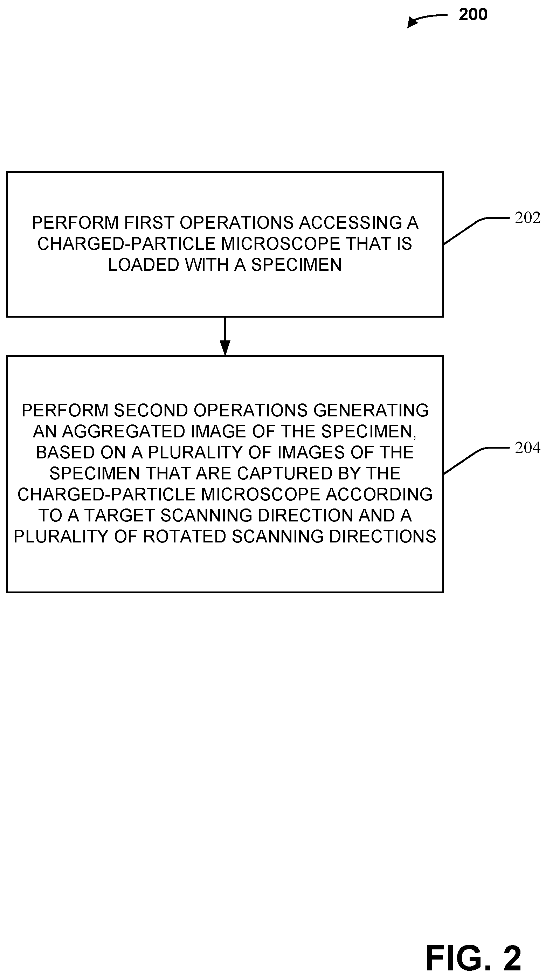

FIG. 2 is an example, non-limiting flow diagram of a computer-implemented method 200 in accordance with various embodiments described herein. The operations of the computer-implemented method 200 may be used in any suitable context to perform any suitable operations (e.g., can be performed by or used in conjunction with any of the various modules, computing devices, or graphical user interfaces described with respect to of FIGs. 1, 21, 22, 23, 24, and 25). Operations are illustrated once each and in a particular order in FIG. 2, but the operations may be reordered or repeated as desired and appropriate (e.g., different operations performed may be performed in parallel, as suitable).

In various aspects, act 202 can include performing first operations accessing a charged-particle microscope that is loaded with a specimen. In various cases, the first logic 104 can perform or otherwise facilitate act 202.

In various aspects, act 204 can include performing second operations generating an aggregated image of the specimen, based on a plurality of images of the specimen that are captured by the charged-particle microscope according to a target scanning direction and a plurality of rotated scanning directions. In various instances, the second logic 106 can perform or otherwise facilitate act 204.

Accordingly, the computer-implemented method 200 can facilitate charging artifact mitigation via scanning direction rotation.

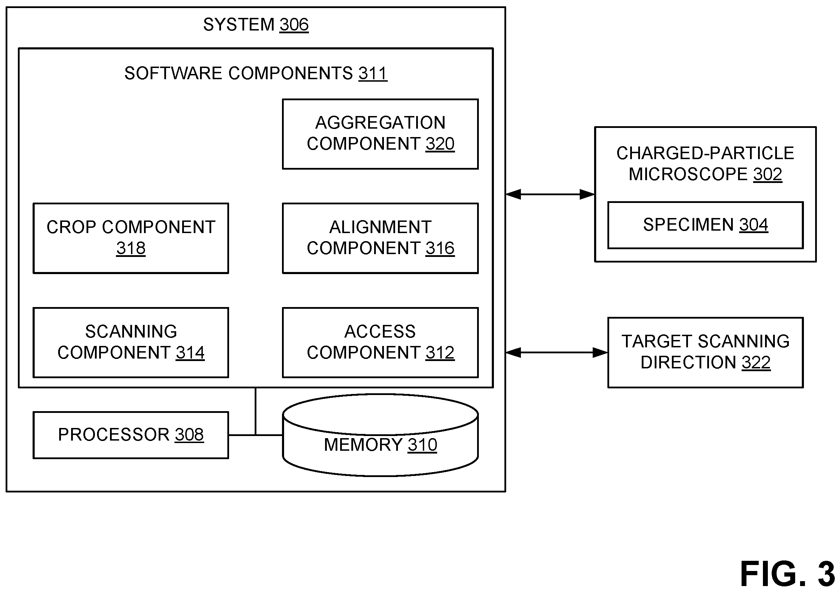

FIG. 3 illustrates a block diagram of an example, non-limiting system that can facilitate charging artifact mitigation via scanning direction rotation in accordance with one or more embodiments described herein.

In various embodiments, there can be a charged-particle microscope 302. In various aspects, the charged-particle microscope 302 can be as described above. That is, the charged-particle microscope 302 can be any suitable computerized device that can leverage its constituent hardware (e.g., electron sources, anodes, condenser lenses, condenser apertures, scan coils, objective lenses, objective apertures, deflectors, condensers, stigmators, electron detectors, X-ray detectors, actuatable specimen stages) to electronically capture any suitable image of any suitable analytical specimen. As a non-limiting example, the charged-particle microscope 302 can be any suitable SEM. As another non-limiting example, the charged-particle microscope 302 can be any suitable dual-beam microscope.

Although not explicitly shown in the figures, the charged-particle microscope 302 can be electronically integrated with any suitable human-computer interface device, which can be remote from or local to the charged-particle microscope 302. Accordingly, a user or technician associated with the charged-particle microscope 302 can interact with or otherwise control the charged-particle microscope 302. Some non-limiting examples of the human-computer interface device can be a keyboard of the charged-particle microscope 302, a keypad of the charged-particle microscope 302, a touchscreen of the charged-particle microscope 302, or a voice-command system of the charged-particle microscope 302.

Although not explicitly shown in the figures, the charged-particle microscope 302 can comprise or otherwise be associated with any suitable number of configurable operating parameters. In various aspects, a configurable operating parameter can be any suitable hardware-related setting or software-related setting of the charged-particle microscope 302 that can guide, affect, or otherwise dictate how the charged-particle microscope 302 runs, operates, or functions with respect to any given analytical specimen and that can be selectively controlled, changed, adjusted, or otherwise set by the user or technician (e.g., via interaction with the human-computer interface device of the charged-particle microscope 302). As a non-limiting example, a configurable operating parameter can be a user-controllable electric voltage setting (e.g., beam voltage) or electric current setting (e.g., beam current), which can allow the user or technician to selectively control an electrode of the charged-particle microscope 302, so as to selectively increase or decrease an electric voltage or electric current within, or that is applied by, the charged-particle microscope 302. As another non-limiting example, a configurable operating parameter can be a user-controllable temperature setting, which can allow the user or technician to control a heater (e.g., stage heater, heating coil) or cooler (e.g., cooling fan, heat pump, refrigerator) of the charged-particle microscope 302, so as to selectively increase or decrease a temperature within, or that is applied by, the charged-particle microscope 302. As still another non-limiting example, a configurable operating parameter can be a user-controllable mechanical actuator setting, which can allow the user or technician to control a mechanical actuator (e.g., electric motor, specimen stage, iris aperture, fluid pump or syringe) of the charged-particle microscope 302, so as to selectively move the mechanical actuator. As yet another non-limiting example, a configurable operating parameter can be a user-controllable optics setting, which can allow the user or technician to control an optical element (e.g., optical lens, an optical deflector) of the charged-particle microscope 302, so as to selectively change an optical quality (e.g., focal spot size or location, astigmatism, defocus) that is applied by the charged-particle microscope 302. In various cases, any configurable operating parameter can be remotely or automatically changeable or adjustable.

In various aspects, one of the configurable operating parameters of the charged-particle microscope 302 can be a scanning direction setting. In various instances, the scanning direction setting can control or otherwise govern which scanning direction is implemented by the charged-particle microscope 302 during any given scan. In various cases, a scanning direction can refer to or otherwise be an axis along which the charged-particle microscope 302 can raster-scan (e.g., in back-and-forth or zig-zag fashion) the surface or interior of any given specimen. In various aspects, the charged-particle microscope 302 can be able to utilize or implement any suitable scanning direction from a 360-degree range of rotation. As a non-limiting example, there can be any suitable reference-plane that is parallel to a specimen stage of the charged-particle microscope 302, where the reference-plane can comprise an center and a referential axis that passes through the center. In such case, there can be another axis in the reference-plane that passes through the center and that is angularly displaced from the referential axis by $\varphi$ degrees, for any suitable real number $0 \leq \varphi \leq 360$. Accordingly, such other axis can be implemented or utilized as a scanning direction by the charged-particle microscope 302. In some aspects, the scanning direction setting can be considered as selectively or controllably configuring $\varphi$.

In various instances, another one of the configurable operating parameters of the charged-particle microscope 302 can be a field of view (FOV) setting. In various cases, the FOV setting can control or otherwise govern which FOV is implemented by the charged-particle microscope 302 during any given scan. In various aspects, a FOV can refer to or otherwise be a rectilinear window of length $L$ and width $W$, for any suitable positive real numbers $L$ and $W$, that can define the total area that the charged-particle microscope 302 raster-scans during any given scan. In other words, any portion of any given specimen or of the specimen stage that is contained within the FOV can be considered as being seen, viewed, or imaged by the charged-particle microscope 302, whereas any portion of the given specimen or of the specimen stage that is outside of the FOV can be considered as not being seen, viewed, or imaged by the charged-particle microscope 302. In some instances, $L$ and $W$ can range from single-digit nanometers to many thousands of micrometers. In some aspects, the FOV setting can be considered as selectively or controllably configuring $L$ and $W$.

In various instances, the charged-particle microscope 302 can be loaded with a specimen 304. As a non-limiting example, the specimen 304 can be presently positioned, located, or otherwise affixed onto the specimen stage of the charged-particle microscope 302, such that the specimen 304 is analyzable or scannable by the charged-particle microscope 302. In various cases, the specimen 304 can be any suitable type of medical, clinical, scientific, or laboratory specimen or sample that can exhibit any suitable physical, chemical, compositional, or other properties, attributes, or characteristics. As a non-limiting example, the specimen 304 can be a lamella taken from a semiconductor substrate or wafer. As another non-limiting example, the specimen 304 can be a sample or fragment taken from a failed load-bearing structure. As even another non-limiting example, the specimen 304 can be a biologic or organic sample.

In various cases, there can be a target scanning direction 322. In various aspects, the target scanning direction 322 can be any suitable scanning direction that is implementable or usable by the charged-particle microscope 302. In various instances, it can be desired for the charged-particle microscope 302 to generate an image of the specimen 304 using or otherwise according to the target scanning direction 322. However, it can be desired for such image to have no, or at most visually inconspicuous, charging artifacts. As described herein, a system 306 can facilitate or accomplish such imaging.

In various embodiments, the system 306 can be electronically integrated, via any suitable wired or wireless electronic connections with the charged-particle microscope 302 or with the target scanning direction 322.

In various aspects, the system 306 can comprise a processor 308 (e.g., computer processing unit, microprocessor) and a non-transitory computer-readable memory 310 that is operably or operatively or communicatively connected or coupled to the processor 308. The non-transitory computer-readable memory 310 can store computer-executable instructions which, upon execution by the processor 308, can cause the processor 308 or other components of the system 306 (e.g., access component 312, scanning component 314, alignment component 316, crop component 318, aggregation component 320) to perform one or more acts. In various embodiments, the non-transitory computer-readable memory 310 can store computer-executable components (e.g., access component 312, scanning component 314, alignment component 316, crop component 318, aggregation component 320), and the processor 308 can execute the computer-executable components.

In various embodiments, the system 306 can comprise an access component 312. In various aspects, the access component 312 can electronically access the charged-particle microscope 302. That is, the access component 312 can electronically communicate or otherwise electronically interact with (e.g., transmit electronic instructions or commands to, receive electronic data from) the charged-particle microscope 302. Accordingly, the access component 312 can be considered as a proxy or conduit through which other components of the system 306 can interact with, communicate with, or otherwise manipulate the charged-particle microscope 302. In various instances, the access component 312 can electronically access the target scanning direction 322. That is, the access component 312 can electronically receive, electronically retrieve, or otherwise electronically obtain the target scanning direction 322, from any suitable electronic source or database (e.g., possibly from the charged-particle microscope 302 or from an associated computerized workstation; the target scanning direction 322 can be indicated by user-provided input to the charged-particle microscope 302 or to the associated computerized workstation). In any case, the access component 312 can be considered as a proxy or conduit through which other components of the system 306 can interact with, control, or otherwise manipulate the target scanning direction 322. However, these are mere non-limiting examples. In other cases, the access component 312 can be omitted, and any other components of the system 306 can communicate or interact directly with the charged-particle microscope 302 or with the target scanning direction 322.

In various embodiments, the system 306 can comprise a scanning component 314. In various aspects, the scanning component 314 can, as described herein, cause the charged-particle microscope 302 to capture a plurality of images of the specimen 304, in accordance with the target scanning direction 322 and in accordance with a plurality of other scanning directions that are respectively rotated from the target scanning direction 322.

In various embodiments, the system 306 can comprise an alignment component 316. In various instances, the alignment component 316 can, as described herein, register or align the plurality of images with whichever image is captured according to the target scanning direction, thereby yielding a plurality of aligned images.

In various embodiments, the system 306 can comprise a crop component 318. In various cases, the crop component 318 can, as described herein, crop out of each of the plurality of aligned images whichever pixels or voxels are not located in whichever image is captured according to the target scanning direction, thereby yielding a plurality of cropped images.

In various embodiments, the system 306 can comprise an aggregation component 320. In various aspects, the aggregation component 320 can, as described herein, aggregate the plurality of cropped images together, thereby yielding an aggregated image. In various cases, the aggregated image can depict the specimen 304 according to the target scanning direction 322, but the aggregated image can lack (or otherwise have substantially reduced) charging artifacts.

Note that, in various instances, the access component 312, the scanning component 314, the alignment component 316, the crop component 318, and the aggregation component 320 can collectively be considered as being one or more software components 311 of the system 306. In various aspects, it should be appreciated that the one or more software components 311 are described primarily herein as comprising five components (e.g., the access component 312, the scanning component 314, the alignment component 316, the crop component 318, and the aggregation component 320) for ease of explanation and illustration. However, the one or more software components 311 are not limited to being implemented as exactly such five components in every embodiment. Indeed, in some embodiments, the functionalities described herein of such five components can be combined in any suitable fashions, so as to be implemented in or by fewer than five components (e.g., in some cases, a single component can perform all of the functionalities that are described herein with respect to the access component 312, the scanning component 314, the alignment component 316, the crop component 318, and the aggregation component 320). In other embodiments, the functionalities described herein of such five components can instead be distributed, separated, split, or fragmented in any suitable fashions, so as to be implemented in or by more than five components (e.g., two or more components can facilitate the functionalities that are performable by the access component 312; two or more components can facilitate the functionalities that are performable by the scanning component 314; two or more components can facilitate the functionalities that are performable by the alignment component 316; two or more components can facilitate the functionalities that are performable by the crop component 318; two or more components can facilitate the functionalities that are performable by the aggregation component 320).

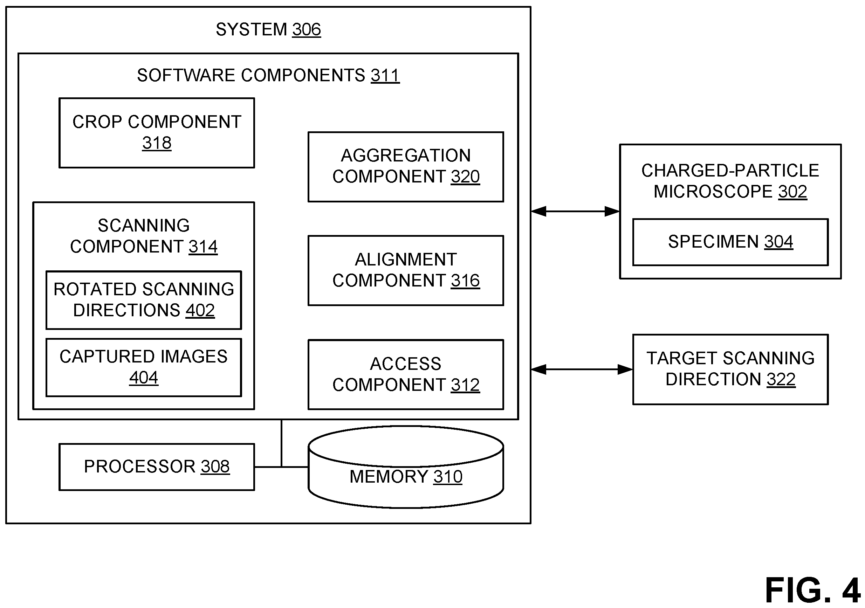

FIG. 4 illustrates a block diagram of an example, non-limiting system including a plurality of rotated scanning directions and a plurality of captured images that can facilitate charging artifact mitigation via scanning direction rotation in accordance with one or more embodiments described herein.

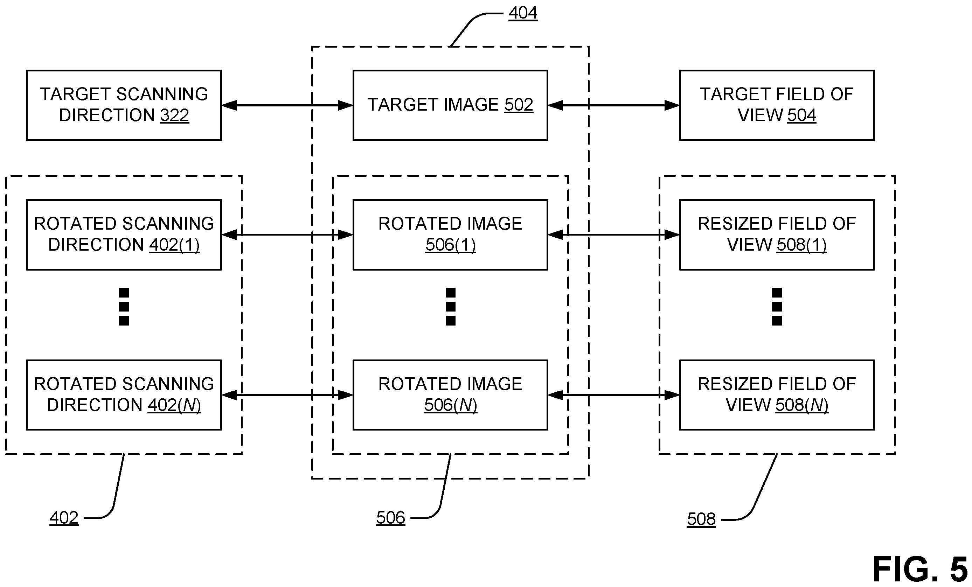

In various embodiments, the scanning component 314 can electronically generate a plurality of captured images 404 of the specimen 304, based on the target scanning direction 322 and based on a plurality of rotated scanning directions 402. Non-limiting aspects are described with respect to FIGs. 5-8.

FIGs. 5-8 illustrate example, non-limiting block diagrams showing how the plurality of rotated scanning directions 402 can be implemented to obtain the plurality of captured images 404 in accordance with one or more embodiments described herein.

First, consider FIG. 5. In various embodiments, the scanning component 314 can electronically instruct, electronically command, or otherwise electronically cause the charged-particle microscope 302 to capture or generate an image of the specimen 304 using or according to the target scanning direction 322. In various aspects, whatever image results from or is obtained by such scan can be referred to as a target image 502. In various cases, the target image 502 can exhibit any suitable format, size, or dimensionality. As a non-limiting example, the target image 502 can be an $x$-by-$y$ array of pixels, for any suitable positive integers $x$ and $y$. As another non-limiting example, the target image 502 can be an $x$-by-$y$-by-$z$ array of voxels, for any suitable positive integers $x$, $y$, and $z$. For ease of explanation and illustration, the herein disclosure treats the target image 502 (and various other images described herein) as two-dimensional pixel arrays, but it is to be appreciated that the herein-described teachings can nevertheless be applied to three-dimensional voxel arrays.

In various instances, the charged-particle microscope 302 can utilize or implement any suitable configurable operating parameter values or states to capture or generate the target image 502. As some non-limiting examples, the charged-particle microscope 302 can utilize any suitable scan speed, any suitable beam voltage, any suitable focal spot size, any suitable detector settings, or any suitable FOV to capture or generate the target image 502. In various cases, whatever FOV that the charged-particle microscope 302 utilizes or implements to generate the target image 502 can be referred to as a target field of view 504 (hereafter "target FOV 504"). Although not explicitly shown in FIG. 5, it should be understood and appreciated that the target FOV 504 can comprise a center or centroid.

Now, in various aspects, the plurality of rotated scanning directions 402 can comprise $n$ directions, for any suitable positive integer $n > 1$: a rotated scanning direction 402(1) to a rotated scanning direction 402($n$). In various instances, each of the plurality of rotated scanning directions 402 can be a scanning direction that is rotated, about the center or centroid of the target FOV 504, by a respective angular displacement away from the target scanning direction 322. In various cases, each of the plurality of rotated scanning directions 402 can have a unique or distinct angular displacement with respect to the target scanning direction 322. In other words, no two of the plurality of rotated scanning directions 402 can be identical to each other or to the target scanning direction 322. As a non-limiting example, the rotated scanning direction 402(1) can have a first angular displacement with respect to the target scanning direction 322, where the first angular displacement is not equal to the angular displacement of any other one of the plurality of rotated scanning directions 402. As another non-limiting example, the rotated scanning direction 402($n$) can have an $n$-th angular displacement with respect to the target scanning direction 322, where the $n$-th angular displacement is not equal to the angular displacement of any other one of the plurality of rotated scanning directions 402.

In some cases, the target scanning direction 322 and the plurality of rotated scanning directions 402 can be radially-symmetric with respect to each other. That is, the target scanning direction 322 and the plurality of rotated scanning directions 402 can collectively span 360 degrees of rotation in any suitable evenly-spaced or uniformly-distributed manner or fashion. In other words, the target scanning direction 322 and the plurality of rotated scanning directions 402 can together be considered as forming a superset of scanning directions, and any two adjacent scanning directions in that superset can be separated by an angular displacement of $\frac{360}{1+n}$ degrees. In some of such situations, the total cardinality of that superset can be even (e.g., $n$ can be odd, so that $n + 1$ is even), which can mean that, for any given scanning direction in that superset, there is another scanning direction in the superset that points 180 degrees away from the given scanning direction. However, this is a mere non-limiting example. In other situations where the superset is radially-symmetric, the total cardinality of that superset can be odd (e.g., $n$ can be even, so that $n + 1$ is odd), which can mean that, for any given scanning direction in that superset, there is no other scanning direction in the superset that points 180 degrees away from the given scanning direction. In even other embodiments, the superset need not be radially-symmetric. In such situations, the target scanning direction 322 and the plurality of rotated scanning directions 402 can be considered as collectively spanning 360 degrees of rotation in any suitable unevenly-spaced or non-uniformly-distributed fashion.

In any case, the scanning component 314 can electronically instruct, electronically command, or otherwise electronically cause the charged-particle microscope 302 to capture or generate a respective image of the specimen 304 using or according to each of the plurality of rotated scanning directions 402. In various instances, whatever images result from or are obtained by such scans can be referred to as a plurality of rotated images 506. As a non-limiting example, the scanning component 314 can instruct, command, or cause the charged-particle microscope 302 to scan the specimen 304 according to the rotated scanning direction 402(1), and whatever image is obtained from such scan can be referred to as a rotated image 506(1). Likewise, as another non-limiting example, the scanning component 314 can instruct, command, or cause the charged-particle microscope 302 to scan the specimen 304 according to the rotated scanning direction 402(*n*), and whatever image is obtained from such scan can be referred to as a rotated image 506(*n*). In various cases, the rotated image 506(1) to the rotated image 506(*n*) can collectively be considered as forming the plurality of rotated images 506.

In various cases, the target image 502 and the plurality or rotated images 506 can be collectively considered as the plurality of captured images 404.

In various aspects, the charged-particle microscope 302 can capture or generate the plurality of rotated images 506 by utilizing or implementing the same configurable operating parameter values or states that the charged-particle microscope 302 used to capture or generate the target image 502, with the exception of scanning direction (as is evident from the herein discussion) and also with the exception of FOV. In particular, the scanning component 314 can instruct, command, or otherwise cause the charged-particle microscope 302 to capture or generate each of the plurality of rotated images 506 using a respectively resized or enlarged FOV that circumscribes the target FOV 504. Accordingly, each of the plurality of rotated images 506 can have or exhibit a total number of pixels that is greater than or equal to the total number of pixels that make up the target image 502. As a non-limiting example, the charged-particle microscope 302 can capture or generate the rotated image 506(1) using a resized FOV 508(1) that is oriented along the rotated scanning direction 402(1) and that is large enough such that the target FOV 504 fits inside of it. In some cases, the size of the resized FOV 508 can depend geometrically or trigonometrically upon the angular displacement between the rotated scanning direction 402(1) and the target scanning direction 322. As another non-limiting example, the charged-particle microscope 302 can capture or generate the rotated image 506(*n*) using a resized FOV 508(*n*) that is oriented along the rotated scanning direction 402(*n*) and that is large enough such that the target FOV 504 fits inside of it. As above, the size of the resized FOV 508 can depend geometrically or trigonometrically upon the angular displacement between the rotated scanning direction 402(*n*) and the target scanning direction 322. Note that the resized FOV 508(1) to the resized FOV 508(*n*) can collectively be considered as forming a plurality of resized FOVs 508. In any case, whatever portions or features of the specimen 304 that are depicted in the target image 502 can also be depicted (albeit from varying or distinct perspectives or orientations) in each of the plurality of rotated images 506.

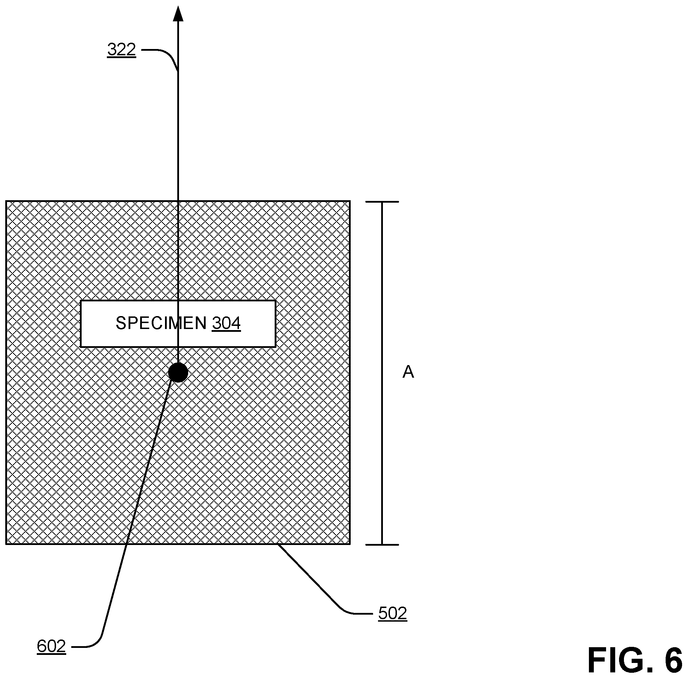

For non-limiting clarification, consider FIGs. 6-8.

FIG. 6 shows a non-limiting, example, block-diagram representation of the target image 502 and the target scanning direction 322. As shown, the target image 502 can visually depict at least some portion of the specimen 304. Although FIG. 6 shows the target image 502, and thus the target FOV 504, as fully containing or encompassing the specimen 304, this is a mere non-limiting example for ease of explanation and illustration. In should be appreciated that the target image 502, and thus the target FOV 504, can instead contain or encompass less than an entirety of the specimen 304. In the non-limiting example of FIG. 6, the target image 502, and thus the target FOV 504, is a square having a side length of A, for any suitable positive real number A. In various aspects, A can be measured in millimeters, micrometers, or nanometers. It should be understood and appreciated that the target image 502, and thus the target FOV 504, can be or have any other suitable shape (e.g., can be a non-square rectangular shape, can be any other suitable rectilinear shape, can even be non-rectilinear shapes in some cases). In various instances, the target image 502, and thus the target FOV 504, can have a center or centroid 602. Although FIG. 6 depicts the target scanning direction 322 as pointing upward from the center or centroid 602, this is a mere non-limiting example. It should be understood and appreciated that the target scanning direction 322 can pass through the center or centroid 602 and point anywhere else in the plane of FIG. 6.

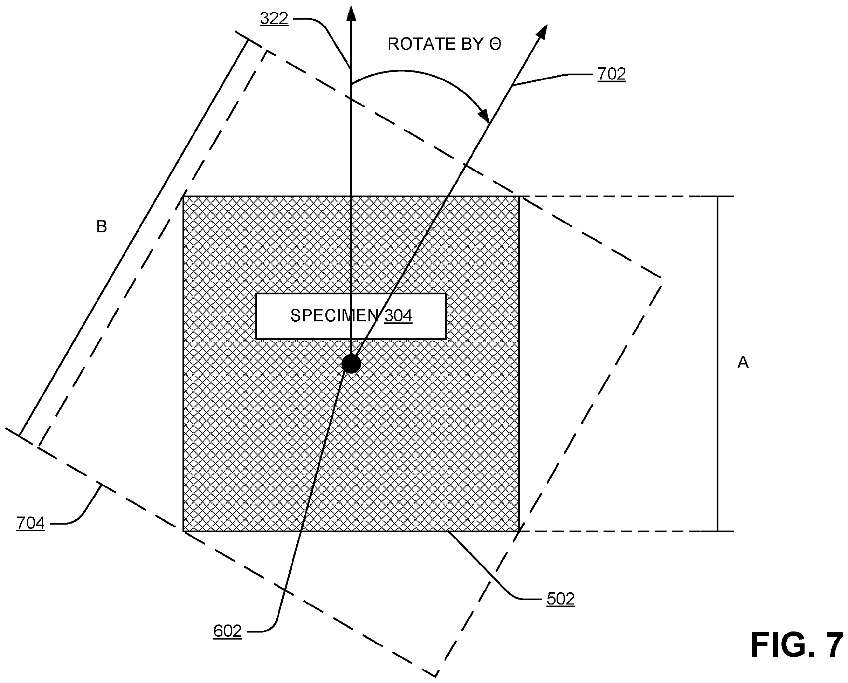

Now, consider FIG. 7. In various embodiments, there can be a rotated scanning direction 702. In various aspects, the rotated scanning direction 702 can be any of the plurality of rotated scanning directions 402. In various instances, the rotated scanning direction 702 can be angularly displaced from the target scanning direction 322 and about the center or centroid 602 by $\theta$ degrees, for any suitable positive real number $0 < \theta < 360$. Note that the strict inequalities can ensure that the rotated scanning direction 702 is not identical to the target scanning direction 322. In various cases, there can be a resized FOV 704. In various aspects, the resized FOV 704 can be whichever of the plurality of resized FOVs 508 that corresponds to the rotated scanning direction 702. In particular, when given the rotated scanning direction 702, the resized FOV 704 can be computed or calculated via any suitable geometric or trigonometric relationships, formulas, or equations, such that the resized FOV 704 circumscribes the target FOV 504 and thus the target image 502. As a non-limiting example, the resized FOV 704 can be a square centered about the center or centroid 602 of side length B, where $B = A(\sin(\theta) + \cos(\theta))$.

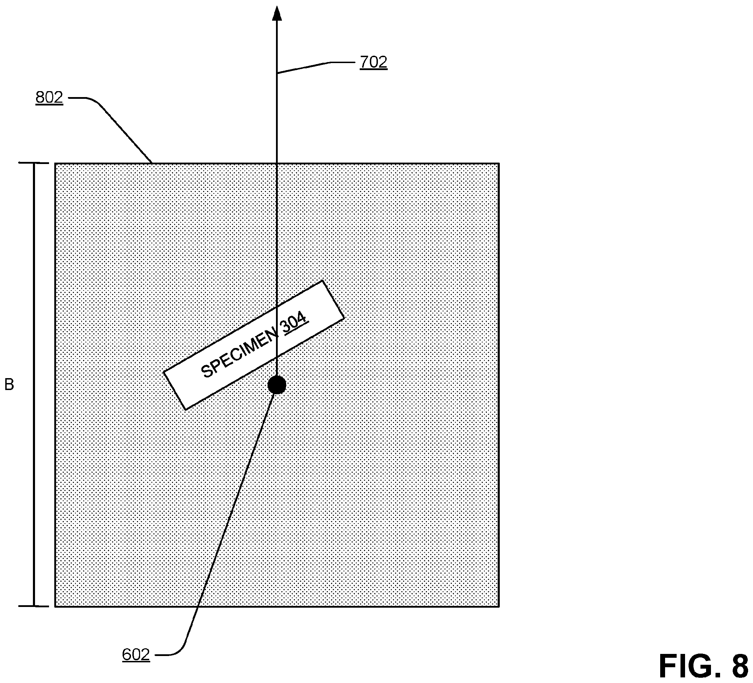

Next, consider FIG. 8. In various aspects, the charged-particle microscope 302 can scan the specimen 304 according to the rotated scanning direction 702 and according to the resized FOV 704. In various instances, such scanning can yield a rotated image 802, where the rotated image 802 can be whichever one of the plurality of rotated images 506 corresponds to the rotated scanning direction 702 and to the resized FOV 704. As shown, because the rotated scanning direction 702 can be angularly displaced from the target scanning direction 322 by $\theta$, the rotated image 802 can depict or illustrate the specimen 304 from a different perspective or orientation than the target image 502. Indeed, if the rotated scanning direction 702 is angularly displaced clockwise from the target scanning direction 322, then the specimen 304 can appear within the rotated image 802 to have been rotated by $\theta$ degrees counterclockwise. Note that the rotated image 802 can be considered as depicting or illustrating (albeit from a different or unique orientation) the same substantive or visual content as the target image 502, in addition to whatever other substantive or visual content falls outside of the target FOV 504 but inside of the resized FOV 704.

In any case, the scanning component 314 can cause the charged-particle microscope 302 to generate the plurality of captured images 404, which can comprise the target image 502 and the plurality of rotated images 506. Note that, in various aspects, the charged-particle microscope 302 can utilize a same, uniform, or constant focal spot size to generate the target image 502 and each of the plurality of rotated images 506. Accordingly, each of the plurality of rotated images 506 can have the same spatial resolution as each other and as the target image 502. In other words, although each of the plurality of rotated images 506 can have the same or a greater number of pixels than the target image 502 (e.g., since their FOVs can have been respectively resized as needed to circumscribe the target FOV 504), all pixels in the plurality of captured images 404 can be considered as having or representing the same physical size as each other (e.g., every pixel can represent a 5-nanometer-by-5-nanometer portion of the specimen 304).

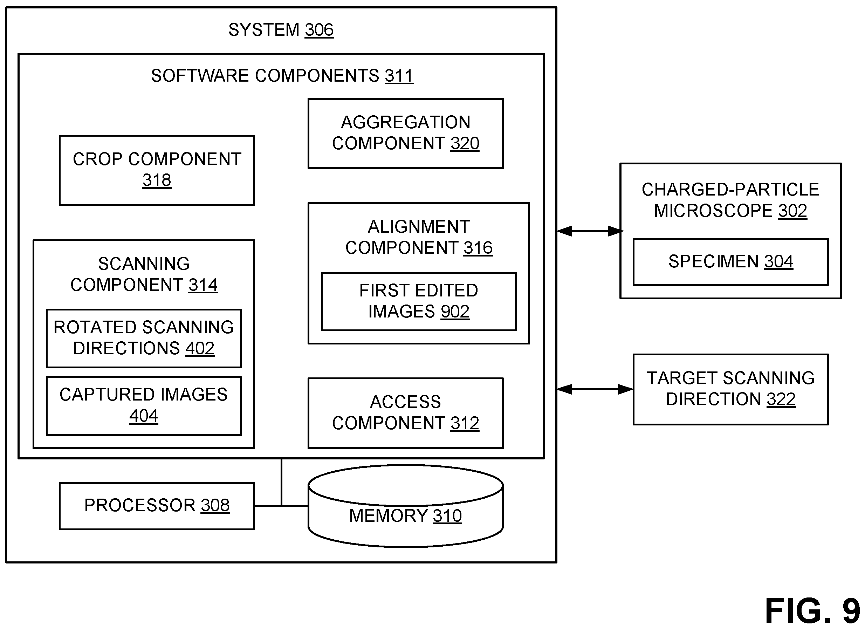

FIG. 9 illustrates a block diagram of an example, non-limiting system including plurality of first edited images that can facilitate charging artifact mitigation via scanning direction rotation in accordance with one or more embodiments described herein.

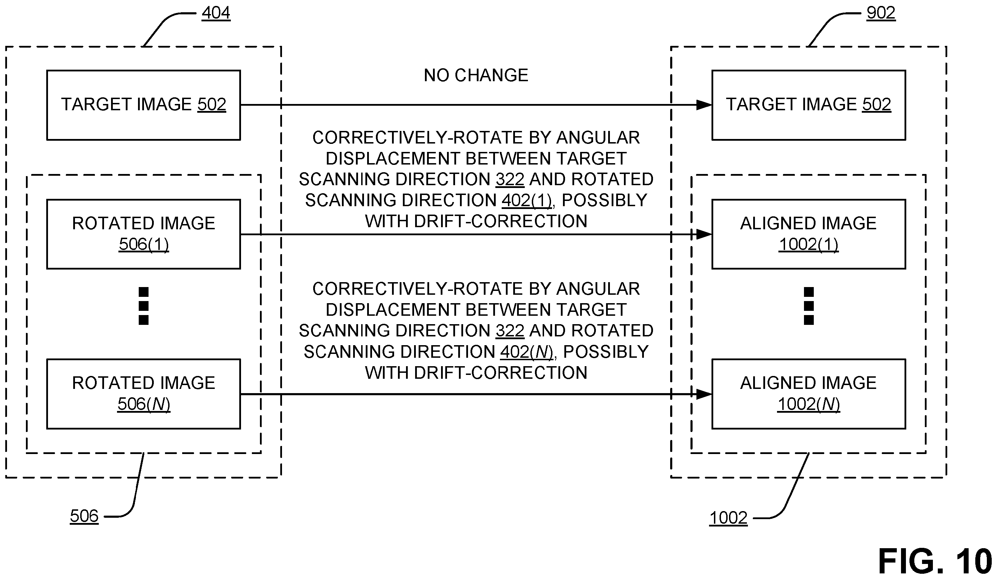

In various embodiments, the alignment component 316 can electronically generate a plurality of first edited images 902, based on the plurality of captured images 404. In particular, the alignment component 316 can facilitate such generation by applying any suitable corrective rotations or other image registration techniques to the plurality of captured images 404. Non-limiting aspects are described with respect to FIGs. 10-12.

FIGs. 10-12 illustrate example, non-limiting block diagrams showing how the plurality of first edited images 902 can be obtained in accordance with one or more embodiments described herein.

First, consider FIG. 10. In various embodiments, the alignment component 316 can electronically apply respective corrective-rotations (possibly supplemented by any other suitable registration techniques) to the plurality of captured images 404, so as to cause the visual content of each of the plurality of captured images 404 to become aligned with that of the target image 502. The plurality of captured images 404 can, after application of such corrective-rotations, be referred to as the plurality of first edited images 902.

More specifically, the alignment component 316 can preserve, maintain, or otherwise refrain from altering or changing the target image 502. Accordingly, the plurality of first edited images 902 can comprise the target image 502 as-is.

Now, in various aspects, the alignment component 316 can respectively apply corrective-rotations to each of the plurality of rotated images 506, so as to convert the plurality of rotated images 506 into a plurality of aligned images 1002.

As a non-limiting example, the alignment component 316 can correctively-rotate the rotated image 506(1) by whatever angular displacement separates the rotated scanning direction 402(1) from the target scanning direction 322, such that whatever portions or features of the specimen 304 that are depicted or illustrated in the rotated image 506(1) become aligned with those that are depicted in the target image 502. In various cases, the alignment component 316 can supplement such corrective-rotation with any other suitable image registration techniques, such as: correlation-based image registration; mutual information-based image registration; or point-based or region-based image registration (e.g., the random sample consensus (RANSAC) registration algorithm). In some cases, such supplemental registration techniques can involve computing a drift or shift vector between the target image 502 and the post-corrective-rotation version of the rotated image 506(1), and using that vector to shift the post-corrective-rotation version of the rotated image 506(1) back toward the target image 502. In any case, application of such corrective-rotation or registration can be considered as converting the rotated image 506(1) into an aligned image 1002(1), where the aligned image 1002(1) can have the same visual or substantive content as the rotated image 506(1), but where that visual or substantive content can now be aligned with (e.g., shown in the same perspective or orientation as) the visual or substantive content of the target image 502.

As another non-limiting example, the alignment component 316 can correctively-rotate the rotated image 506(n) by whatever angular displacement separates the rotated scanning direction 402(n) from the target scanning direction 322, such that whatever portions or features of the specimen 304 that are depicted or illustrated in the rotated image 506(n) become aligned with those that are depicted in the target image 502. As above, the alignment component 316 can supplement such corrective-rotation with any other suitable image registration techniques (e.g., drift or shift correction) as desired or appropriate. In any case, application of such corrective-rotation or registration can be considered as converting the rotated image 506(n) into an aligned image 1002(n), where the aligned image 1002(n) can have the same visual or substantive content as the rotated image 506(n), but where that visual or substantive content can now be aligned with (e.g., shown in the same perspective or orientation as) the visual or substantive content of the target image 502.

Note that the aligned image 1002(1) to the aligned image 1002($n$) can be collectively considered as forming the plurality of aligned images 1002. In various cases, the plurality of aligned images 1002 and the target image 502 can collectively be considered as forming the plurality of first edited images 902.

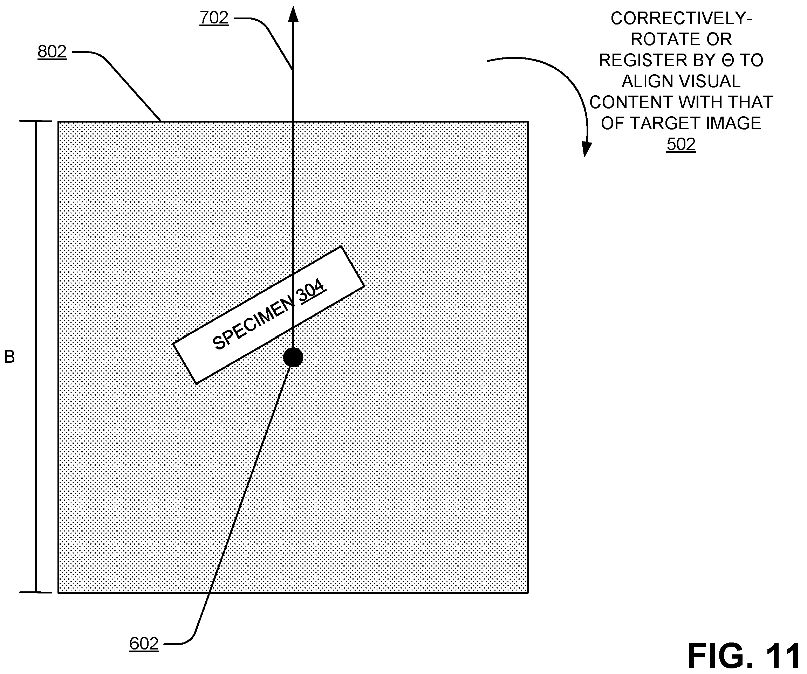

For non-limiting clarification, consider FIGs. 11-12.

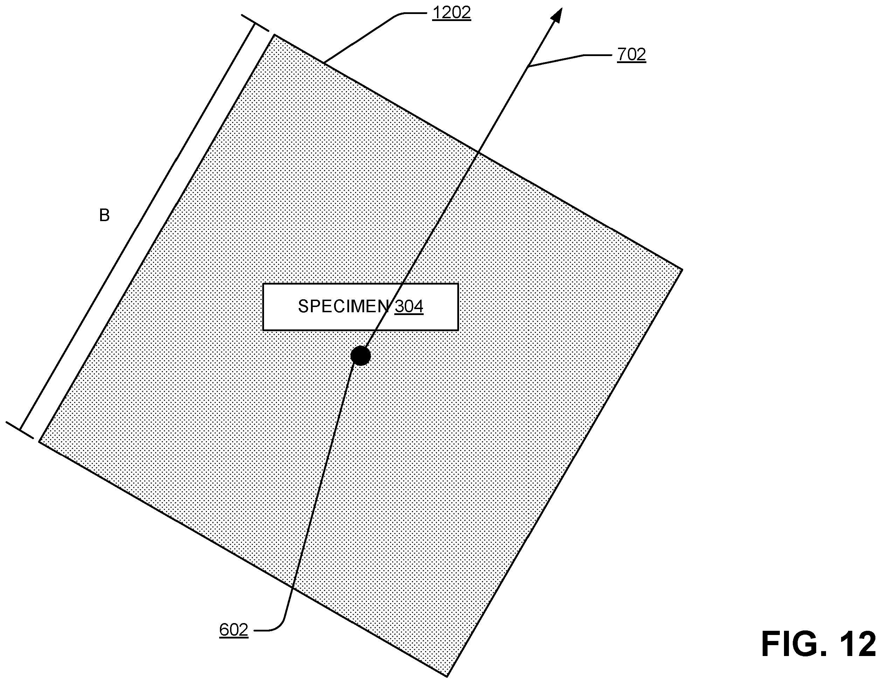

FIG. 11 shows the rotated image 802 described above. In various embodiments, as shown, the rotated image 802 can be correctively-rotated (or otherwise registered, such as via drift correction), so that its visual or substantive content becomes aligned with the visual or substantive content of the target image 502. In the non-limiting example of FIG. 11, such corrective-rotation can be accomplished by rotating the rotated image 802 clockwise by $\theta$. The result of such corrective-rotation is shown in FIG. 12. As can be seen, such corrective-rotation can cause the rotated image 802 to now become or be converted to an aligned image 1202 (e.g., one of 1002) that depicts the specimen 304 from the same perspective or orientation as the target image 502 (e.g., compare the perspective or orientation of the specimen 304 as shown in FIG. 12 to the perspective or orientation of the specimen 304 as shown in FIGs. 6-7).

Note that, in some cases, corrective-rotation (and other registration, if applicable) can be considered as redefining or reorienting the pixel rows and pixel columns of the rotated image 802. Indeed, the rotated image 802 can have pixel rows and columns that are in line with the rotated scanning direction 702 rather than with the target scanning direction 322. However, the aligned image 1202 can have pixel rows and columns that are in line with the target scanning direction 322 rather than with the rotated scanning direction 702.

In any case, each of the plurality of first edited images 902 can show, illustrate, or depict the specimen 304 from the perspective or orientation of the target image 502.

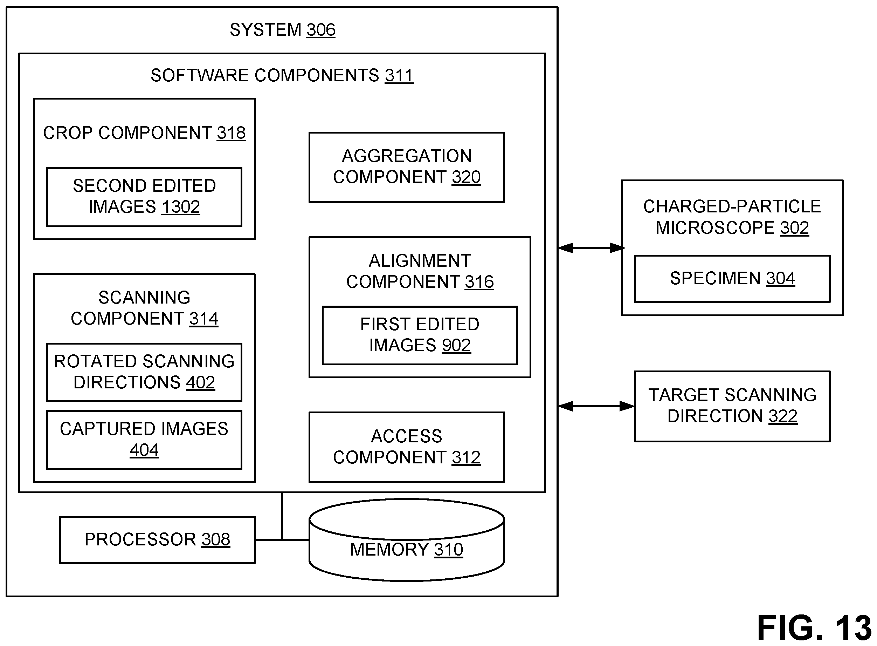

FIG. 13 illustrates a block diagram of an example, non-limiting system including a plurality of second edited images that can facilitate charging artifact mitigation via scanning direction rotation in accordance with one or more embodiments described herein.

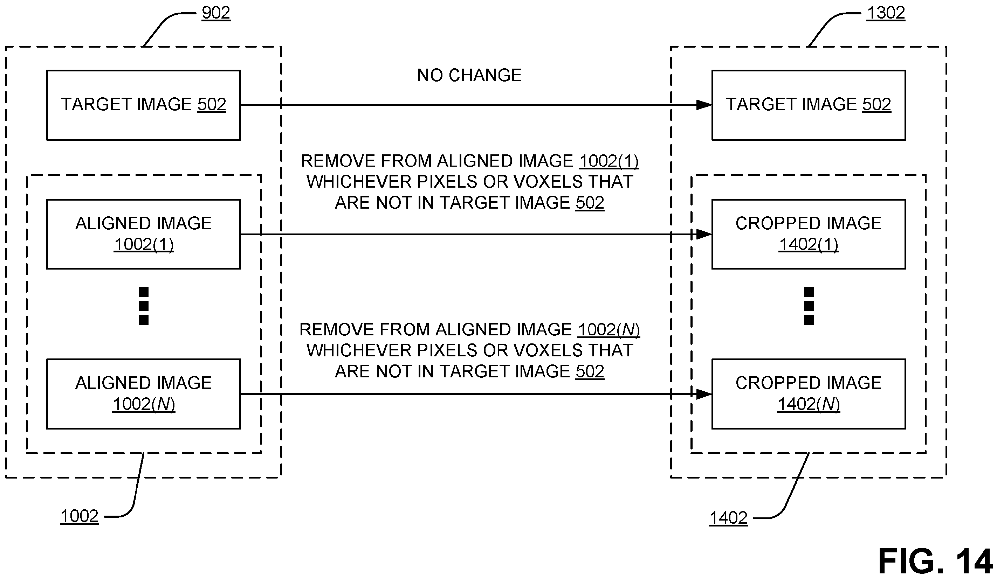

In various embodiments, the crop component 318 can electronically generate a plurality of second edited images 1302, based on the plurality of first edited images 902. In particular, the crop component 318 can facilitate such generation by applying any suitable cropping or other pixel deletion techniques to the plurality of first edited images 902. Non-limiting aspects are described with respect to FIGs. 14-16.

FIGs. 14-16 illustrate example, non-limiting block diagrams showing how the plurality of second edited images 1302 can be obtained in accordance with one or more embodiments described herein.

First, consider FIG. 14. In various embodiments, the crop component 318 can electronically crop or otherwise remove from the plurality of first edited images 902 any pixels that are not present within the target image 502, so as to cause the visual content of each of the plurality of first edited images 902 to become aligned with that of the target image 502. The plurality of first edited images 902 can, after application of such cropping or removal, be referred to as the plurality of second edited images 1302.

More specifically, the crop component 318 can preserve, maintain, or otherwise refrain from altering or changing the target image 502. Accordingly, the plurality of second edited images 1302 can comprise the target image 502 as-is.

Now, in various aspects, the crop component 318 can crop-out or remove from each of the plurality of aligned images 1002 any pixels that are absent from the target image 502, so as to convert the plurality of aligned images 1002 into a plurality of cropped images 1402.

As a non-limiting example, the crop component 318 can remove, delete, discard, or otherwise crop from the aligned image 1002(1) any pixels that are not present in the target image 502. Indeed, the aligned image 1002(1) can be considered as having or exhibiting the resized FOV 508(1), which can circumscribe the target FOV 504. Thus, since the aligned image 1002(1) and the target image 502 can have the same spatial resolution as each other, the aligned image 1002(1) can be considered as comprising or containing all of the same pixels as the target image 502 (e.g., all of the pixels that fall within the target FOV 504), and as also comprising or containing additional pixels that are not in the target image 502 (e.g., all of the pixels that fall within the resized FOV 508(1) but that fall outside of the target FOV 504). So, the crop component 318 can remove or delete whichever pixels of the aligned image 1002(1) that are not within the target image 502, and the result of such removal or deletion can be a cropped image 1402(1). In other words, the cropped image 1402(1) can be the remainder of the aligned image 1002(1) after any pixels that are not within the target image 502 are removed from the aligned image 1002(1). Accordingly, the cropped image 1402(1) can be considered as being the same size as (e.g., as having the same number or arrangement of pixels as) the target image 502.

As another non-limiting example, the crop component 318 can remove, delete, discard, or otherwise crop from the aligned image 1002(n) any pixels that are not present in the target image 502. Indeed, the aligned image 1002(n) can be considered as having or exhibiting the resized FOV 508(n), which can circumscribe the target FOV 504. So, since the aligned image 1002(n) and the target image 502 can have the same spatial resolution as each other, the aligned image 1002(n) can be considered as comprising or containing all of the same pixels as the target image 502 (e.g., all of the pixels that fall within the target FOV 504), and as also comprising or containing additional pixels that are not in the target image 502 (e.g., all of the pixels that fall within the resized FOV 508(n) but that fall outside of the target FOV 504). Thus, the crop component 318 can remove or delete whichever pixels of the aligned image 1002(n) that are not within the target image 502, and the result of such removal or deletion can be a cropped image 1402(n). That is, the cropped image 1402(n) can be the remainder of the aligned image 1002(n) after any pixels that are not within the target image 502 are removed from the aligned image 1002(n). Accordingly, the cropped image 1402(n) can be considered as being the same size as (e.g., as having the same number or arrangement of pixels as) the target image 502.

Note that the cropped image 1402(1) to the cropped image 1402(n) can be collectively considered as forming the plurality of cropped images 1402. In various cases, the plurality of cropped images 1402 and the target image 502 can collectively be considered as forming the plurality of second edited images 1302.

In various aspects, each of the set of second edited images 1302 can be considered as containing or exhibiting conspicuous or visibly noticeable charging artifacts that are oriented along a corresponding scanning direction. As a non-limiting example, the target image 502 can have been captured according to the target scanning direction 322. Accordingly, the target image 502 can exhibit or have charging artifacts that are physically oriented parallel to the target scanning direction 322. As another non-limiting example, the cropped image 1402(1) can have been captured according to the rotated scanning direction 402(1). So, the cropped image 1402(1) can exhibit or have charging artifacts that are physically oriented parallel to the rotated scanning direction 402(1). As even another non-limiting example, the cropped image 1402(n) can have been captured according to the rotated scanning direction 402(n). Thus, the cropped image 1402(n) can exhibit or have charging artifacts that are physically oriented parallel to the rotated scanning direction 402(n).

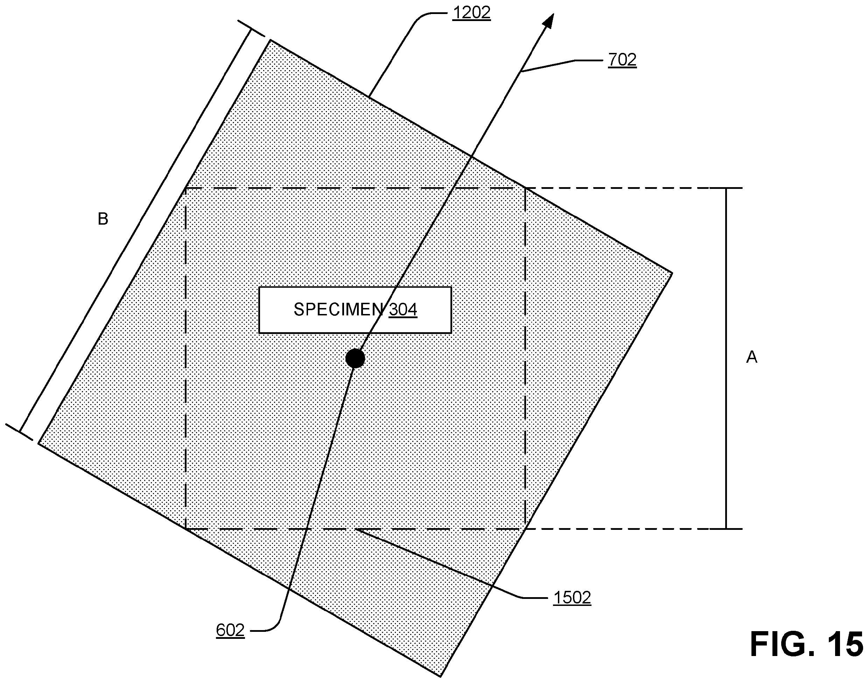

For non-limiting clarification, consider FIGs. 15-16.

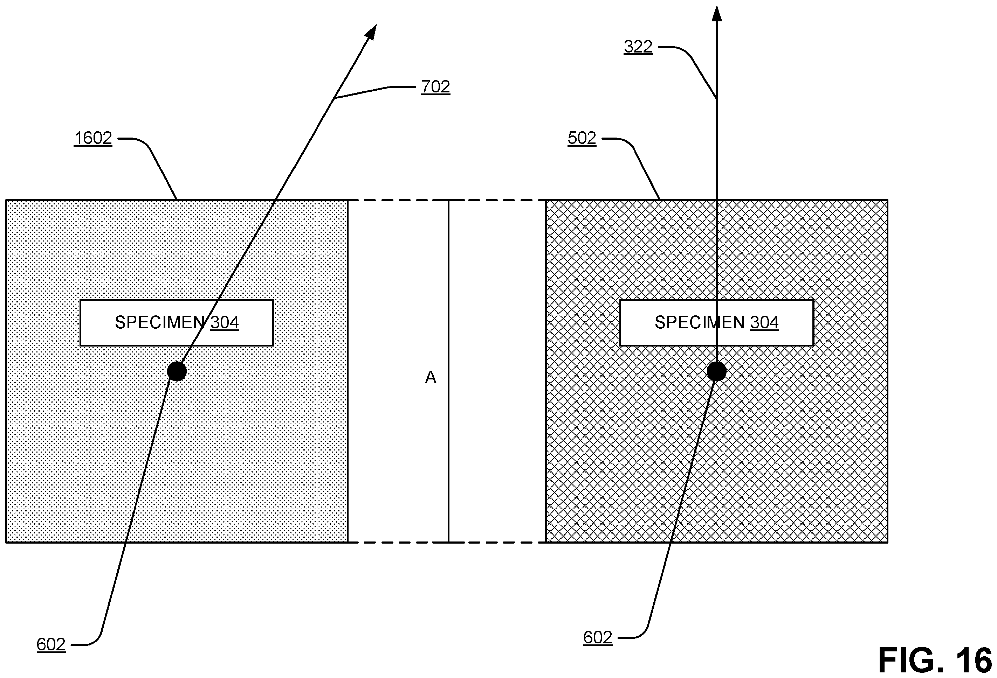

FIG. 15 shows the aligned image 1202 discussed above. In various aspects, a numeral 1502 can be considered as demarcating a boundary between pixels of the aligned image 1202 that are contained within the target image 502 (and thus within the target FOV 504) and pixels of the aligned image 1202 that fall outside the target image 502 (and thus outside the target FOV 504). In various aspects, whichever pixels that are inside of the boundary demarcated by the numeral 1502 can be preserved or maintained, whereas whichever pixels that are instead outside of that boundary can be deleted, removed, or cropped out. FIG. 16 shows the result of such deletion, removal, or cropping. Indeed, such deletion, removal, or cropping can be considered as converting the aligned image 1202 into a cropped image 1602 (e.g., one of 1402). As shown, the cropped image 1602 can have the same size (e.g., side length A) as the target image 502, and can also depict the specimen 304 from the same perspective or orientation as the target image 502. However, the target image 502 can have charging artifacts that are visually parallel to the target scanning direction 322. In contrast, the cropped image 1602 can instead have charging artifacts that are visually parallel to the rotated scanning direction 702. In other words, although the cropped image 1602 and the target image 502 can show the specimen 304 according to the same perspective as each other, the charging artifacts of the cropped image 1602 can be differently located or differently spatially-distributed than those of the target image 502, such that different portions of the specimen 304 can be obscured or obfuscated in the target image 502 than in the cropped image 1602.

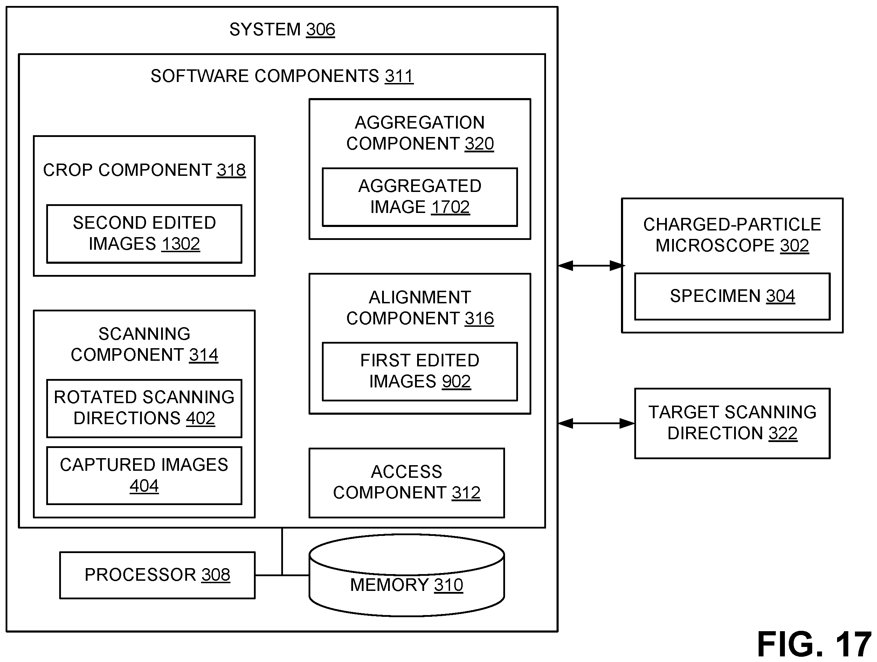

FIG. 17 illustrates a block diagram of an example, non-limiting system including an aggregated image that can facilitate charging artifact mitigation via scanning direction rotation in accordance with one or more embodiments described herein.

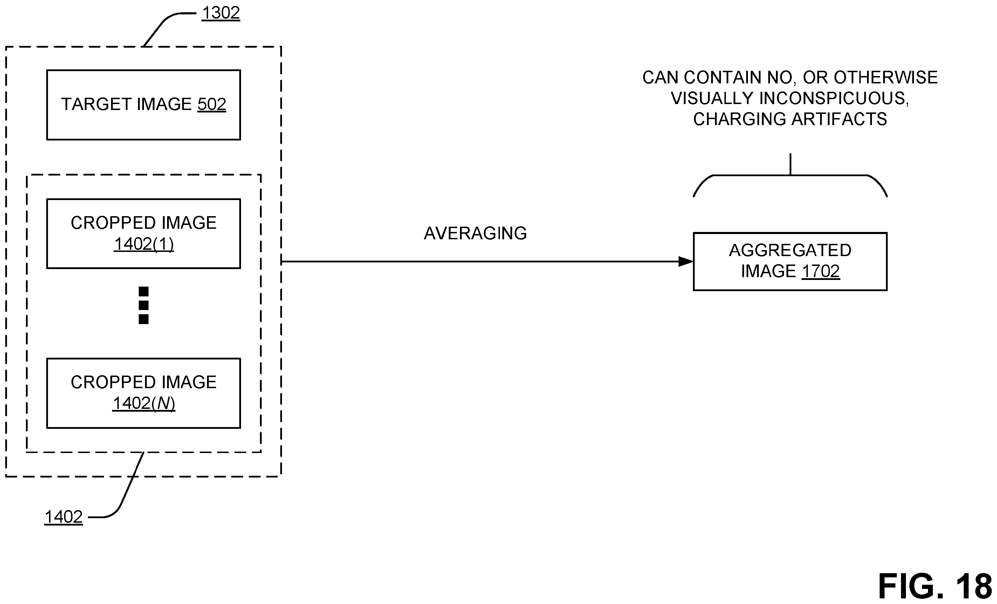

In various embodiments, the aggregation component 320 can electronically generate an aggregated image 1702, based on the plurality of second edited images 1302. Non-limiting aspects are described with respect to FIG. 18.

FIG. 18 illustrates an example, non-limiting block diagram showing how the aggregated image 1702 can be obtained in accordance with one or more embodiments described herein.

In various embodiments, as shown, the aggregation component 320 can electronically aggregate the plurality of second edited images 1302 together in any suitable fashion, and the computational result of such aggregation can be referred to as the aggregated image 1702. As a non-limiting example, the aggregated image 1702 can be equal to a pixel-wise average of the target image 502 and the plurality of cropped images 1402. In various instances, as mentioned above, each of the plurality of second edited images 1302 can have uniquely-positioned or uniquely-located charging artifacts that are visually conspicuous or noticeable. However, the aggregated image 1702 can, in stark contrast, have no, negligible, or otherwise significantly less visible or less noticeable charging artifacts. Indeed, because each of the plurality of second edited images 1302 can be considered as having uniquely or distinctly located charging artifacts that are not identically present in any others of the plurality of second edited images 1302, all of such charging artifacts can cancel or drop out during averaging.

As a non-limiting example, the target image 502 can have unique or distinct charging artifacts that are parallel to the target scanning direction 322. Because no other image can be captured using the target scanning direction 322, whatever features or portions of the specimen 304 that are obscured, covered, or distorted by charging artifacts in the target image 502 can be unobscured, uncovered, or undistorted by charging artifacts in the remaining images of the plurality of second edited images 1302. Thus, those features or portions of the specimen 304 can be strongly visible in the aggregated image 1702, since many more of the plurality of second edited images 1302 depict such features or portions than obscure such features or portions.

As another non-limiting example, the cropped image 1402(1) can have unique or distinct charging artifacts that are parallel to the rotated scanning direction 402(1). Because no other image can be captured using the rotated scanning direction 402(1), whatever features or portions of the specimen 304 that are obscured, covered, or distorted by charging artifacts in the cropped image 1402(1) can be unobscured, uncovered, or undistorted by charging artifacts in the remaining images of the plurality of second edited images 1302. So, those features or portions of the specimen 304 can be strongly visible in the aggregated image 1702, since many more of the plurality of second edited images 1302 depict such features or portions than obscure such features or portions.

As still another non-limiting example, the cropped image 1402($n$) can have unique or distinct charging artifacts that are parallel to the rotated scanning direction 402($n$). Because no other image can be captured using the rotated scanning direction 402($n$), whatever features or portions of the specimen 304 that are obscured, covered, or distorted by charging artifacts in the cropped image 1402($n$) can be unobscured, uncovered, or undistorted by charging artifacts in the remaining images of the plurality of second edited images 1302. Accordingly, those features or portions of the specimen 304 can be strongly visible in the aggregated image 1702, since many more of the plurality of second edited images 1302 depict such features or portions than obscure such features or portions.

In this way, charging artifacts can be mitigated or attenuated by leveraging scanning direction rotation, regardless of microscope-type, and regardless of specimen type.

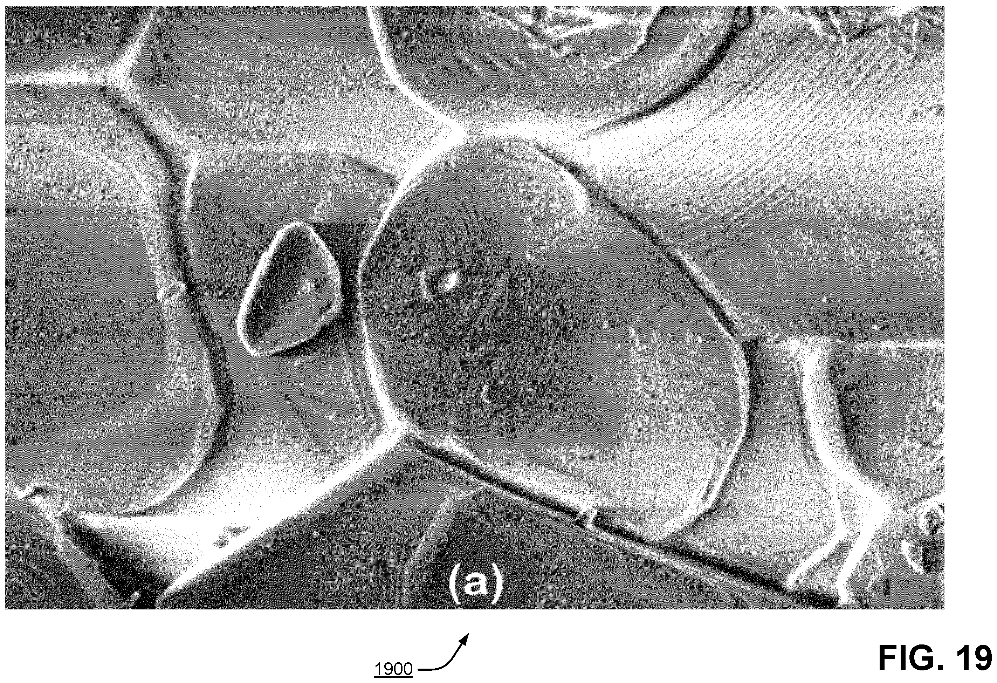

FIGs. 19-20 illustrate example, non-limiting experimental results in accordance with one or more embodiments described herein.

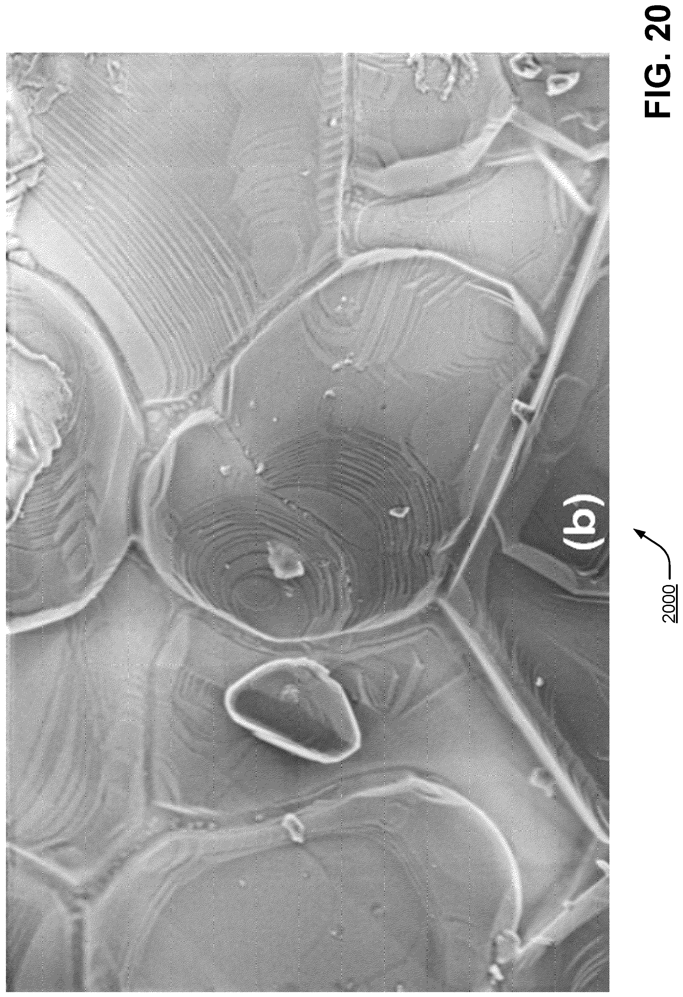

In particular, FIG. 19 shows an SEM image 1900 of a ceramic specimen that was captured using a left-to-right scanning direction. As can be seen, the SEM image 1900 exhibits significant charging artifacts (e.g., significant black and white streaking along the left-to-right direction). Now, FIG. 20 shows an aggregated SEM image 2000 generated in accordance with various embodiments described herein. Specifically, for this particular experimental reduction to practice, a total of 8 uniformly distributed scanning directions (e.g., $n + 1$, with $n = 7$, and with each pair of adjacent scanning directions being separated by an angular displacement of 45 degrees) were implemented, with the SEM image 1900 being treated as the target image 502. As can be seen, the aggregated SEM image 2000 exhibits no noticeable or conspicuous charging artifacts or other distortions. Accordingly, these experimental results help to verify and validate that various embodiments described herein constitute a tangible, real-world technical improvement in the field of charged-particle microscopy.

The scientific instrument systems, methods, or techniques disclosed herein may include interactions with a human user (e.g., via a user local computing device 2320 discussed herein with reference to FIG. 23). These interactions may include providing information to the user (e.g., information regarding the operation of a scientific instrument such as the scientific instrument 2310 of FIG. 23, information regarding a sample being analyzed or other test or measurement performed by a scientific instrument, information retrieved from a local or remote database, or other information) or providing an option for a user to input commands (e.g., to control the operation of a scientific instrument such as the scientific instrument 2310 of FIG. 23, or to control the analysis of data generated by a scientific instrument), queries (e.g., to a local or remote database), or other information. In some embodiments, these interactions may be performed through a graphical user interface (GUI) that includes a visual display on a display device (e.g., a display device 2210 discussed herein with reference to FIG. 22) that provides outputs to the user and/or prompts the user to provide inputs (e.g., via one or more input devices, such as a keyboard, mouse, trackpad, or touchscreen, included in other I/O devices 2212 discussed herein with reference to FIG. 22). The scientific instrument systems, methods, or techniques disclosed herein may include any suitable GUIs for interaction with a user.

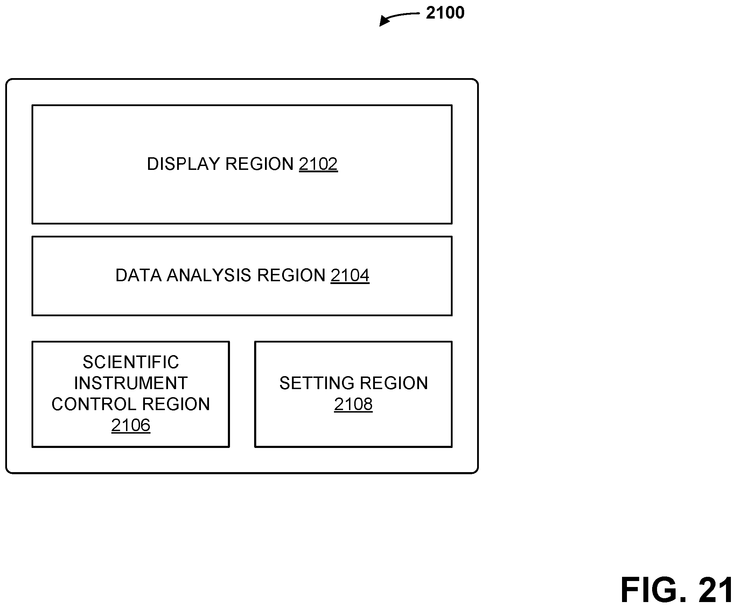

FIG. 21 depicts an example graphical user interface 2100 (hereafter "GUI 2100") that can be used in the performance of some or all of the support methods or techniques disclosed herein, in accordance with various embodiments. In various aspects, the GUI 2100 can be provided on any suitable electronic display (e.g., a display device 2210 discussed herein with reference to FIG. 22) of a computing device (e.g., a computing device 2200 discussed herein with reference to FIG. 22) of a scientific instrument support system (e.g., a scientific instrument support system 2300 discussed herein with reference to FIG. 23), and a user or technician can interact with the GUI 2100 using any suitable input device (e.g., any of other I/O devices 2212 discussed herein with reference to FIG. 22) and input technique (e.g., movement of a cursor, motion capture, facial recognition, gesture detection, voice recognition, actuation of buttons).

The GUI 2100 can include a data display region 2102, a data analysis region 2104, a scientific instrument control region 2106, and a setting region 2108. The particular number and arrangement of regions depicted in FIG. 21 is merely illustrative, and any number and arrangement of regions, including any desired features, can be included in other embodiments of the GUI 2100.

The data display region 2102 can display data generated by a scientific instrument (e.g., a scientific instrument 2310 discussed herein with reference to FIG. 23).

The data analysis region 2104 can display any suitable data analysis results (e.g., the results of analyzing the data illustrated in the data display region 2102 or other data). In some embodiments, the data display region 2102 and the data analysis region 2104 can be combined in the GUI 2100 (e.g., to include both data output from a scientific instrument and some analysis of the data in a common graph or region).

The scientific instrument control region 2106 can include options that allow a user or technician to control a scientific instrument (e.g., the scientific instrument 2310 discussed herein with reference to FIG. 23). For example, the scientific instrument control region 2106 can include configurable parameters that govern operation of such scientific instrument (e.g., configurable parameters that govern voltages or electric currents of the scientific instrument, that govern interior temperatures of the scientific instrument, or that govern fluid flow rates of the scientific instrument).

The setting region 2108 can include options that allow a user or technician to control any features or functions of the GUI 2100 (or of other GUIs) or to perform common computing operations with respect to the data display region 2102 and the data analysis region 2104 (e.g., saving data on a storage device, such as the storage device 2204 discussed herein with reference to FIG. 22, sending data to another user, labeling data).

As noted above, the scientific instrument module 102 can be implemented by one or more computing devices. FIG. 22 is a block diagram of a computing device 2200 that can perform some or all of the scientific instrument methods or techniques disclosed herein, in accordance with various embodiments. In some embodiments, the scientific instrument module 102 can be implemented by a single instance of the computing device 2200 or by multiple instances of the computing device 2200. Further, as discussed below, the computing device 2200 (or multiple instances thereof) that implements the scientific instrument module 102 can be part of one or more of a scientific instrument 2310, a user local computing device 2320, a service local computing device 2330, or a remote computing device 2340 of FIG. 23.

The computing device 2200 is illustrated as having a number of components, but any one or more of these components can be omitted or duplicated, as suitable for the application and setting. In some embodiments, some or all of the components included in the computing device 2200 can be attached to one or more motherboards and enclosed in a housing (e.g., including plastic, metal, or other materials). In some embodiments, some these components can be fabricated onto a single system-on-a-chip (SoC) (e.g., an SoC may include one or more instances of a processing device 2202 and one or more instances of a storage device 2204). Additionally, in various embodiments, the computing device 2200 can omit one or more of the components illustrated in FIG. 22, but can include interface circuitry (not shown) for coupling to the one or more omitted components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface) . For example, the computing device 2200 can omit a display device 2210, but can include display device interface circuitry (e.g., a connector and driver circuitry) to which a display device 2210 can be coupled.

The computing device 2200 can include a processing device 2202 (e.g., one or more processing devices). As used herein, the term "processing device" can refer to any device or portion of a device that processes electronic data from registers or memory to transform that electronic data into other electronic data that may be stored in registers or memories. The processing device 2202 can include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 2200 can include a storage device 2204 (e.g., one or more storage devices). The storage device 2204 can include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In some embodiments, the storage device 2204 can include memory that shares a die with a processing device 2202. In such an embodiment, the memory may be used as cache memory and may include embedded dynamic random access memory (eDRAM) or spin transfer torque magnetic random access memory (STT-MRAM), for example. In some embodiments, the storage device 2204 can include non-transitory computer readable media having instructions thereon that, when executed by one or more processing devices (e.g., the processing device 2202), cause the computing device 2200 to perform any appropriate ones of or portions of the methods disclosed herein.

The computing device 2200 can include an interface device 2206 (e.g., one or more instances of the interface device 2206). The interface device 2206 can include one or more communication chips, connectors, or other hardware and software to govern communications between the computing device 2200 and other computing devices. For example, the interface device 2206 can include circuitry for managing wireless communications for the transfer of data to and from the computing device 2200. The term "wireless" and its derivatives may be used to describe circuits, devices, systems, methods, techniques, or communications channels that may communicate data through the use of modulated electromagnetic radiation through a nonsolid medium. The term does not imply that the associated devices do not contain any wires, although in some embodiments they might not. Circuitry included in the interface device 2206 for managing wireless communications may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2")). In some embodiments, circuitry included in the interface device 2206 for managing wireless communications can operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In some embodiments, circuitry included in the interface device 2206 for managing wireless communications can operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In some embodiments, circuitry included in the interface device 2206 for managing wireless communications may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In some embodiments, the interface device 2206 may include one or more antennas (e.g., one or more antenna arrays) to receipt and/or transmission of wireless communications.

In some embodiments, the interface device 2206 can include circuitry for managing wired communications, such as electrical, optical, or any other suitable communication protocols. For example, the interface device 2206 can include circuitry to support communications in accordance with Ethernet technologies. In some embodiments, the interface device 2206 can support both wireless and wired communication, or can support multiple wired communication protocols or multiple wireless communication protocols. For example, a first set of circuitry of the interface device 2206 may be dedicated to shorter-range wireless communications such as Wi-Fi or Bluetooth, and a second set of circuitry of the interface device 2206 may be dedicated to longer-range wireless communications such as global positioning system (GPS), EDGE, GPRS, CDMA, WiMAX, LTE, EV-DO, or others. In some embodiments, a first set of circuitry of the interface device 2206 can be dedicated to wireless communications, and a second set of circuitry of the interface device 2206 can be dedicated to wired communications.

The computing device 2200 can include battery/power circuitry 2208. The battery/power circuitry 2208 can include one or more energy storage devices (e.g., batteries or capacitors) or circuitry for coupling components of the computing device 2200 to an energy source separate from the computing device 2200 (e.g., alternating current line power).

The computing device 2200 can include a display device 2210 (e.g., multiple display devices). The display device 2210 can include any visual indicators, such as a heads-up display, a computer monitor, a projector, a touchscreen display, a liquid crystal display (LCD), a light-emitting diode display, or a flat panel display.

The computing device 2200 can include other input/output (I/O) devices 2212. The other I/O devices 2212 can include one or more audio output devices (e.g., speakers, headsets, earbuds, alarms), one or more audio input devices (e.g., microphones or microphone arrays), location devices (e.g., GPS devices in communication with a satellite-based system to receive a location of the computing device 2200), audio codecs, video codecs, printers, sensors (e.g., thermocouples or other temperature sensors, humidity sensors, pressure sensors, vibration sensors, accelerometers, gyroscopes), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 2200 can have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultra mobile personal computer), a desktop computing device, or a server computing device or other networked computing component.

One or more computing devices implementing any of the scientific instrument modules, methods, or techniques disclosed herein may be part of a scientific instrument support system. FIG. 23 is a block diagram of an example scientific instrument support system 2300 in which some or all of the scientific instrument support methods disclosed herein may be performed, in accordance with various embodiments. The scientific instrument modules, methods, or techniques disclosed herein (e.g., the scientific instrument module 102; the computer-implemented method 200; the system 306) can be implemented by one or more of a scientific instrument 2310, a user local computing device 2320, a service local computing device 2330, or a remote computing device 2340 of the scientific instrument support system 2300.

Any of the scientific instrument 2310, the user local computing device 2320, the service local computing device 2330, or the remote computing device 2340 can include any of the embodiments of the computing device 2200, and any of the scientific instrument 2310, the user local computing device 2320, the service local computing device 2330, or the remote computing device 2340 can take the form of any appropriate ones of the embodiments of the computing device 2200.

The scientific instrument 2310, the user local computing device 2320, the service local computing device 2330, or the remote computing device 2340 may each include a processing device 2302, a storage device 2304, and an interface device 2306. The processing device 2302 may take any suitable form, including any form of the processing device 2202, and the processing devices 2302 included in different ones of the scientific instrument 2310, the user local computing device 2320, the service local computing device 2330, or the remote computing device 2340 may take the same form or different forms. The storage device 2304 may take any suitable form, including any form of the storage device 2204, and the storage devices 2304 included in different ones of the scientific instrument 2310, the user local computing device 2320, the service local computing device 2330, or the remote computing device 2340 may take the same form or different forms. The interface device 2306 may take any suitable form, including any form of the interface device 2206, and the interface devices 2306 included in different ones of the scientific instrument 2310, the user local computing device 2320, the service local computing device 2330, or the remote computing device 2340 may take the same form or different forms.

The scientific instrument 2310, the user local computing device 2320, the service local computing device 2330, and the remote computing device 2340 can be in communication with other elements of the scientific instrument support system 2300 via communication pathways 2308. The communication pathways 2308 may communicatively couple the interface devices 2306 of different ones of the elements of the scientific instrument support system 2300, as shown, and may be wired or wireless communication pathways (e.g., in accordance with any of the communication techniques discussed herein with reference to the interface device 2206). The particular scientific instrument support system 2300 depicted in FIG. 23 includes communication pathways between each pair of the scientific instrument 2310, the user local computing device 2320, the service local computing device 2330, and the remote computing device 2340, but this "fully connected" implementation is merely illustrative, and in various embodiments, various ones of the communication pathways 2308 may be absent. For example, in some embodiments, a service local computing device 2330 can lack a direct communication pathway 2308 between its interface device 2306 and the interface device 2306 of the scientific instrument 2310, but can instead communicate with the scientific instrument 2310 via the communication pathway 2308 between the service local computing device 2330 and the user local computing device 2320 and the communication pathway 2308 between the user local computing device 2320 and the scientific instrument 2310.

The scientific instrument 2310 may include any appropriate scientific instrument, such as the charged-particle microscope 302.

The user local computing device 2320 can be a computing device (e.g., in accordance with any of the embodiments of the computing device 2200) that is local to a user of the scientific instrument 2310. In some embodiments, the user local computing device 2320 may also be local to the scientific instrument 2310, but this need not be the case; for example, a user local computing device 2320 that is in a user's home or office may be remote from, but in communication with, the scientific instrument 2310 so that the user may use the user local computing device 2320 to control or access data from the scientific instrument 2310. In some embodiments, the user local computing device 2320 may be a laptop, smartphone, or tablet device. In some embodiments the user local computing device 2320 can be a portable computing device.

The service local computing device 2330 can be a computing device (e.g., in accordance with any of the embodiments of the computing device 2200) that is local to an entity that services the scientific instrument 2310. For example, the service local computing device 2330 may be local to a manufacturer of the scientific instrument 2310 or to a third-party service company. In some embodiments, the service local computing device 2330 can communicate with the scientific instrument 2310, the user local computing device 2320, or the remote computing device 2340 (e.g., via a direct communication pathway 2308 or via multiple "indirect" communication pathways 2308, as discussed above) to receive data regarding the operation of the scientific instrument 2310, the user local computing device 2320, or the remote computing device 2340 (e.g., the results of self-tests of the scientific instrument 2310, calibration coefficients used by the scientific instrument 2310, the measurements of sensors associated with the scientific instrument 2310). In some embodiments, the service local computing device 2330 may communicate with the scientific instrument 2310, the user local computing device 2320, or the remote computing device 2340 (e.g., via a direct communication pathway 2308 or via multiple "indirect" communication pathways 2308, as discussed above) to transmit data to the scientific instrument 2310, the user local computing device 2320, or the remote computing device 2340 (e.g., to update programmed instructions, such as firmware, in the scientific instrument 2310, to initiate the performance of test or calibration sequences in the scientific instrument 2310, to update programmed instructions, such as software, in the user local computing device 2320 or the remote computing device 2340). A user of the scientific instrument 2310 can utilize the scientific instrument 2310 or the user local computing device 2320 to communicate with the service local computing device 2330 to report a problem with the scientific instrument 2310 or the user local computing device 2320, to request a visit from a technician to improve the operation of the scientific instrument 2310, to order consumables or replacement parts associated with the scientific instrument 2310, or for other purposes.

The remote computing device 2340 can be a computing device (e.g., in accordance with any of the embodiments of the computing device 2200 discussed herein) that is remote from the scientific instrument 2310 or from the user local computing device 2320. In some embodiments, the remote computing device 2340 can be included in a datacenter or other large-scale server environment. In some embodiments, the remote computing device 2340 may include network-attached storage (e.g., as part of the storage device 2304). The remote computing device 2340 can store data generated by the scientific instrument 2310, perform analyses of the data generated by the scientific instrument 2310 (e.g., in accordance with programmed instructions), facilitate communication between the user local computing device 2320 and the scientific instrument 2310, or facilitate communication between the service local computing device 2330 and the scientific instrument 2310.

In some embodiments, one or more of the elements of the scientific instrument support system 2300 illustrated in FIG. 23 can be omitted. Further, in some embodiments, multiple ones of various ones of the elements of the scientific instrument support system 2300 of FIG. 23 may be present. For example, a scientific instrument support system 2300 can include multiple user local computing devices 2320 (e.g., different user local computing devices 2320 associated with different users or in different locations). In another example, a scientific instrument support system 2300 may include multiple scientific instruments 2310, all in communication with service local computing device 2330 and/or a remote computing device 2340; in such an embodiment, the service local computing device 2330 may monitor these multiple scientific instruments 2310, and the service local computing device 2330 may cause updates or other information may be "broadcast" to multiple scientific instruments 2310 at the same time. Different ones of the scientific instruments 2310 in a scientific instrument support system 2300 can be located close to one another (e.g., in the same room) or farther from one another (e.g., on different floors of a building, in different buildings, in different cities, etc.). In some embodiments, a scientific instrument 2310 can be connected to an Internet-of-Things (IoT) stack that allows for command and control of the scientific instrument 2310 through a web-based application, a virtual or augmented reality application, a mobile application, or a desktop application. Any of these applications can be accessed by a user operating the user local computing device 2320 in communication with the scientific instrument 2310 by the intervening remote computing device 2340. In some embodiments, a scientific instrument 2310 may be sold by the manufacturer along with one or more associated user local computing devices 2320 as part of a local scientific instrument computing unit 2312.

In some embodiments, different ones of the scientific instruments 2310 included in a scientific instrument support system 2300 may be different types of scientific instruments 2310; for example, one scientific instrument 2310 may be a mass spectrometer, while another scientific instrument 2310 may be a chromatograph or autosampler. In some such embodiments, the remote computing device 2340 or the user local computing device 2320 can combine data from different types of scientific instruments 2310 included in a scientific instrument support system 2300.

In various instances, machine learning algorithms or models can be implemented in any suitable way to facilitate any suitable aspects described herein. To facilitate some of the above-described machine learning aspects of various embodiments, consider the following discussion of artificial intelligence (AI). Various embodiments described herein can employ artificial intelligence to facilitate automating one or more features or functionalities. The components can employ various AI-based schemes for carrying out various embodiments/examples disclosed herein. In order to provide for or aid in the numerous determinations (e.g., determine, ascertain, infer, calculate, predict, prognose, estimate, derive, forecast, detect, compute) described herein, components described herein can examine the entirety or a subset of the data to which it is granted access and can provide for reasoning about or determine states of the system or environment from a set of observations as captured via events or data. Determinations can be employed to identify a specific context or action, or can generate a probability distribution over states, for example. The determinations can be probabilistic; that is, the computation of a probability distribution over states of interest based on a consideration of data and events. Determinations can also refer to techniques employed for composing higher-level events from a set of events or data.

Such determinations can result in the construction of new events or actions from a set of observed events or stored event data, whether or not the events are correlated in close temporal proximity, and whether the events and data come from one or several event and data sources. Components disclosed herein can employ various classification (explicitly trained (e.g., via training data) as well as implicitly trained (e.g., via observing behavior, preferences, historical information, receiving extrinsic information, and so on)) schemes or systems (e.g., support vector machines, neural networks, expert systems, Bayesian belief networks, fuzzy logic, data fusion engines, and so on) in connection with performing automatic or determined action in connection with the claimed subject matter. Thus, classification schemes or systems can be used to automatically learn and perform a number of functions, actions, or determinations.

A classifier can map an input attribute vector, $z = (z_1, z_2, z_3, z_4, z_n)$, to a confidence that the input belongs to a class, as by f(z) = *confidence*(*class*). Such classification can employ a probabilistic or statistical-based analysis (e.g., factoring into the analysis utilities and costs) to determinate an action to be automatically performed. A support vector machine (SVM) can be an example of a classifier that can be employed. The SVM operates by finding a hyper-surface in the space of possible inputs, where the hyper-surface attempts to split the triggering criteria from the non-triggering events. Intuitively, this makes the classification correct for testing data that is near, but not identical to training data. Other directed and undirected model classification approaches include, e.g., naïve Bayes, Bayesian networks, decision trees, neural networks, fuzzy logic models, or probabilistic classification models providing different patterns of independence, any of which can be employed. Classification as used herein also is inclusive of statistical regression that is utilized to develop models of priority.

In order to provide additional context for various embodiments described herein, FIG. 24 and the following discussion are intended to provide a brief, general description of a suitable computing environment 2400 in which the various embodiments of the embodiment described herein can be implemented. While the embodiments have been described above in the general context of computer-executable instructions that can run on one or more computers, those skilled in the art will recognize that the embodiments can be also implemented in combination with other program modules or as a combination of hardware and software.

Generally, program modules include routines, programs, components, data structures, etc., that perform particular tasks or implement particular abstract data types. Moreover, those skilled in the art will appreciate that the inventive methods can be practiced with other computer system configurations, including single-processor or multi-processor computer systems, minicomputers, mainframe computers, Internet of Things (IoT) devices, distributed computing systems, as well as personal computers, hand-held computing devices, microprocessor-based or programmable consumer electronics, and the like, each of which can be operatively coupled to one or more associated devices.

The illustrated embodiments of the embodiments herein can be also practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data or unstructured data.

Computer-readable storage media can include, but are not limited to, random access memory (RAM), read only memory (ROM), electrically erasable programmable read only memory (EEPROM), flash memory or other memory technology, compact disk read only memory (CD-ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible or non-transitory media which can be used to store desired information. In this regard, the terms "tangible" or "non-transitory" herein as applied to storage, memory or computer-readable media, are to be understood to exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infrared and other wireless media.

With reference again to FIG. 24, the example environment 2400 for implementing various embodiments of the aspects described herein includes a computer 2402, the computer 2402 including a processing unit 2404, a system memory 2406 and a system bus 2408. The system bus 2408 couples system components including, but not limited to, the system memory 2406 to the processing unit 2404. The processing unit 2404 can be any of various commercially available processors. Dual microprocessors and other multi-processor architectures can also be employed as the processing unit 2404.

The system bus 2408 can be any of several types of bus structure that can further interconnect to a memory bus (with or without a memory controller), a peripheral bus, and a local bus using any of a variety of commercially available bus architectures. The system memory 2406 includes ROM 2410 and RAM 2412. A basic input/output system (BIOS) can be stored in a non-volatile memory such as ROM, erasable programmable read only memory (EPROM), EEPROM, which BIOS contains the basic routines that help to transfer information between elements within the computer 2402, such as during startup. The RAM 2412 can also include a high-speed RAM such as static RAM for caching data.

The computer 2402 further includes an internal hard disk drive (HDD) 2414 (e.g., EIDE, SATA), one or more external storage devices 2416 (e.g., a magnetic floppy disk drive (FDD) 2416, a memory stick or flash drive reader, a memory card reader, etc.) and a drive 2420, e.g., such as a solid state drive, an optical disk drive, which can read or write from a disk 2422, such as a CD-ROM disc, a DVD, a BD, etc. Alternatively, where a solid state drive is involved, disk 2422 would not be included, unless separate. While the internal HDD 2414 is illustrated as located within the computer 2402, the internal HDD 2414 can also be configured for external use in a suitable chassis (not shown). Additionally, while not shown in environment 2400, a solid state drive (SSD) could be used in addition to, or in place of, an HDD 2414. The HDD 2414, external storage device(s) 2416 and drive 2420 can be connected to the system bus 2408 by an HDD interface 2424, an external storage interface 2426 and a drive interface 2428, respectively. The interface 2424 for external drive implementations can include at least one or both of Universal Serial Bus (USB) and Institute of Electrical and Electronics Engineers (IEEE) 1394 interface technologies. Other external drive connection technologies are within contemplation of the embodiments described herein.

The drives and their associated computer-readable storage media provide nonvolatile storage of data, data structures, computer-executable instructions, and so forth. For the computer 2402, the drives and storage media accommodate the storage of any data in a suitable digital format. Although the description of computer-readable storage media above refers to respective types of storage devices, it should be appreciated by those skilled in the art that other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 2412, including an operating system 2430, one or more application programs 2432, other program modules 2434 and program data 2436. All or portions of the operating system, applications, modules, or data can also be cached in the RAM 2412. The systems and methods described herein can be implemented utilizing various commercially available operating systems or combinations of operating systems.

Computer 2402 can optionally comprise emulation technologies. For example, a hypervisor (not shown) or other intermediary can emulate a hardware environment for operating system 2430, and the emulated hardware can optionally be different from the hardware illustrated in FIG. 24. In such an embodiment, operating system 2430 can comprise one virtual machine (VM) of multiple VMs hosted at computer 2402. Furthermore, operating system 2430 can provide runtime environments, such as the Java runtime environment or the .NET framework, for applications 2432. Runtime environments are consistent execution environments that allow applications 2432 to run on any operating system that includes the runtime environment. Similarly, operating system 2430 can support containers, and applications 2432 can be in the form of containers, which are lightweight, standalone, executable packages of software that include, e.g., code, runtime, system tools, system libraries and settings for an application.

Further, computer 2402 can be enable with a security module, such as a trusted processing module (TPM). For instance with a TPM, boot components hash next in time boot components, and wait for a match of results to secured values, before loading a next boot component. This process can take place at any layer in the code execution stack of computer 2402, e.g., applied at the application execution level or at the operating system (OS) kernel level, thereby enabling security at any level of code execution.

A user can enter commands and information into the computer 2402 through one or more wired/wireless input devices, e.g., a keyboard 2438, a touch screen 2440, and a pointing device, such as a mouse 2442. Other input devices (not shown) can include a microphone, an infrared (IR) remote control, a radio frequency (RF) remote control, or other remote control, a joystick, a virtual reality controller or virtual reality headset, a game pad, a stylus pen, an image input device, e.g., camera(s), a gesture sensor input device, a vision movement sensor input device, an emotion or facial detection device, a biometric input device, e.g., fingerprint or iris scanner, or the like. These and other input devices are often connected to the processing unit 2404 through an input device interface 2444 that can be coupled to the system bus 2408, but can be connected by other interfaces, such as a parallel port, an IEEE 1394 serial port, a game port, a USB port, an IR interface, a BLUETOOTH® interface, etc.

A monitor 2446 or other type of display device can be also connected to the system bus 2408 via an interface, such as a video adapter 2448. In addition to the monitor 2446, a computer typically includes other peripheral output devices (not shown), such as speakers, printers, etc.

The computer 2402 can operate in a networked environment using logical connections via wired or wireless communications to one or more remote computers, such as a remote computer(s) 2450. The remote computer(s) 2450 can be a workstation, a server computer, a router, a personal computer, portable computer, microprocessor-based entertainment appliance, a peer device or other common network node, and typically includes many or all of the elements described relative to the computer 2402, although, for purposes of brevity, only a memory/storage device 2452 is illustrated. The logical connections depicted include wired/wireless connectivity to a local area network (LAN) 2454 or larger networks, e.g., a wide area network (WAN) 2456. Such LAN and WAN networking environments are commonplace in offices and companies, and facilitate enterprise-wide computer networks, such as intranets, all of which can connect to a global communications network, e.g., the Internet.

When used in a LAN networking environment, the computer 2402 can be connected to the local network 2454 through a wired or wireless communication network interface or adapter 2458. The adapter 2458 can facilitate wired or wireless communication to the LAN 2454, which can also include a wireless access point (AP) disposed thereon for communicating with the adapter 2458 in a wireless mode.

When used in a WAN networking environment, the computer 2402 can include a modem 2460 or can be connected to a communications server on the WAN 2456 via other means for establishing communications over the WAN 2456, such as by way of the Internet. The modem 2460, which can be internal or external and a wired or wireless device, can be connected to the system bus 2408 via the input device interface 2444. In a networked environment, program modules depicted relative to the computer 2402 or portions thereof, can be stored in the remote memory/storage device 2452. It will be appreciated that the network connections shown are example and other means of establishing a communications link between the computers can be used.

When used in either a LAN or WAN networking environment, the computer 2402 can access cloud storage systems or other network-based storage systems in addition to, or in place of, external storage devices 2416 as described above, such as but not limited to a network virtual machine providing one or more aspects of storage or processing of information. Generally, a connection between the computer 2402 and a cloud storage system can be established over a LAN 2454 or WAN 2456 e.g., by the adapter 2458 or modem 2460, respectively. Upon connecting the computer 2402 to an associated cloud storage system, the external storage interface 2426 can, with the aid of the adapter 2458 or modem 2460, manage storage provided by the cloud storage system as it would other types of external storage. For instance, the external storage interface 2426 can be configured to provide access to cloud storage sources as if those sources were physically connected to the computer 2402.

The computer 2402 can be operable to communicate with any wireless devices or entities operatively disposed in wireless communication, e.g., a printer, scanner, desktop or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH® wireless technologies. Thus, the communication can be a predefined structure as with a conventional network or simply an ad hoc communication between at least two devices.

FIG. 25 is a schematic block diagram of a sample computing environment 2500 with which the disclosed subject matter can interact. The sample computing environment 2500 includes one or more client(s) 2510. The client(s) 2510 can be hardware or software (e.g., threads, processes, computing devices). The sample computing environment 2500 also includes one or more server(s) 2530. The server(s) 2530 can also be hardware or software (e.g., threads, processes, computing devices). The servers 2530 can house threads to perform transformations by employing one or more embodiments as described herein, for example. One possible communication between a client 2510 and a server 2530 can be in the form of a data packet adapted to be transmitted between two or more computer processes. The sample computing environment 2500 includes a communication framework 2550 that can be employed to facilitate communications between the client(s) 2510 and the server(s) 2530. The client(s) 2510 are operably connected to one or more client data store(s) 2520 that can be employed to store information local to the client(s) 2510. Similarly, the server(s) 2530 are operably connected to one or more server data store(s) 2540 that can be employed to store information local to the servers 2530.

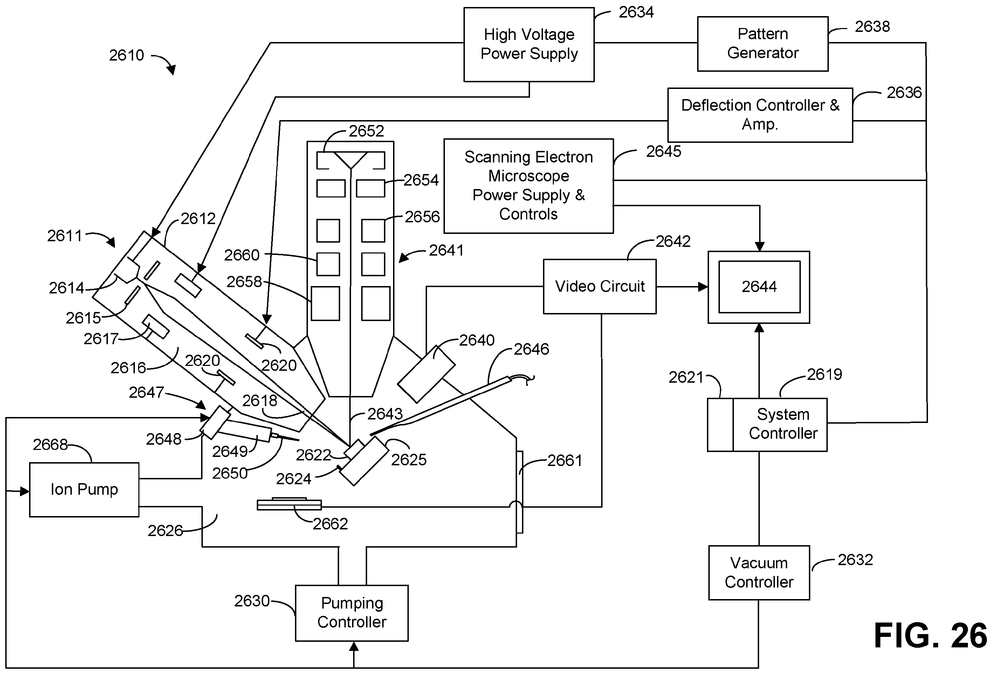

An example, non-limiting apparatus for performing various embodiments described herein is shown in FIG. 26. FIG. 26 illustrates a non-limiting example of a dual beam system 2610 with a vertically mounted scanning electron microscope (SEM) column and a focused ion beam (FIB) column mounted at an angle of approximately 52 degrees from the vertical. Such dual beam systems are commercially available, for example, from FEI Company, Hillsboro, Oregon, the assignee of the present application. While FIG. 26 shows an example of suitable microscopy hardware with which various embodiments described herein can be implemented, it is to be appreciated that such microscopy hardware is non-limiting. In other words, various embodiments described herein can be implemented in conjunction with any other suitable types of microscopy hardware. The dual beam system 2610 is a non-limiting example of the charged-particle microscope 302 or of any other scientific instruments discussed above.

A scanning electron microscope 2641, along with a power supply and control unit 2645, can be provided with the dual beam system 2610. An electron beam 2643 can be emitted from a cathode 2652 by applying voltage between the cathode 2652 and an anode 2654. The electron beam 2643 can be focused to a fine spot by means of a condensing lens 2656 and an objective lens 2658. The electron beam 2643 can be scanned two-dimensionally on any suitable specimen by means of a deflection coil 2660. Operation of the condensing lens 2656, the objective lens 2658, or the deflection coil 2660 can be controlled by the power supply and control unit 2645.

The electron beam 2643 can be focused onto a substrate 2622, which can be on a movable X-Y stage 2625 within a lower chamber 2626. When the electrons in the electron beam 2643 strike the substrate 2622, secondary electrons can be emitted. These secondary electrons can be detected by a secondary electron detector 2640 as discussed below. A scanning transmission electron microscopy (STEM) detector 2662, located beneath a STEM sample holder 2624 and the movable X-Y stage 2625, can collect electrons that are transmitted through the sample mounted on the STEM sample holder 2624 as discussed above.

The dual beam system 2610 can also include a focused ion beam (FIB) system 2611 which can comprise an evacuated chamber having an upper neck portion 2612 within which can be located an ion source 2614 and a focusing column 2616 including extractor electrodes and an electrostatic optical system (in some cases, the upper neck portion can also be referred to as an ion column 2612). The axis of the focusing column 2616 can be tilted 52 degrees (or any other suitable angular displacement) from the axis of the electron column. The ion column 2612 can include an ion source 2614, an extraction electrode 2615, a focusing element 2617, deflection elements 2620, and a focused ion beam 2618. The focused ion beam 2618 can pass from the ion source 2614 through the focusing column 2616 and between electrostatic deflection means schematically indicated at numeral 2620 toward the substrate 2622, which can comprise, for example, a semiconductor device positioned on the movable X-Y stage 2625 within the lower chamber 2626.

The movable X-Y stage 2625 can move in a horizontal plane (along X and Y axes) and vertically (along Z axis). The movable X-Y stage 2625 can tilt approximately sixty (60) degrees and rotate about the Z axis. In some embodiments, a separate STEM sample stage (not shown) can be used. Such a STEM sample stage can be moveable in the X, Y, and Z axes. A door 2661 can be opened for inserting the substrate 2622 onto the movable X-Y stage 2625 or also for servicing an internal gas supply reservoir, if one is used. The door 2661 can be interlocked so that it cannot be opened if the system is under vacuum.

An ion pump 2668 can be employed for evacuating the neck portion 2612. The chamber 2626 can be evacuated with a turbomolecular and mechanical pumping system 2630 under the control of a vacuum controller 2632. Such vacuum system can provide within the chamber 2626 a vacuum of between approximately $1 \times 10^{-7}$ Torr and $5 \times 10^{-4}$ Torr. If an etch assisting, an etch retarding gas, or a deposition precursor gas is used, the chamber background pressure may rise, typically to about $1 \times 10^{-5}$ Torr.

A high voltage power supply 2634 can provide an appropriate acceleration voltage to electrodes in the focusing column 2616 for energizing and the focused ion beam 2618. When it strikes the substrate 2622, material can be sputtered (that is, physically ejected) from the sample. Alternatively, the focused ion beam 2618 can decompose a precursor gas to deposit a material.

The high voltage power supply 2634 can be connected to the ion source 2614 (which can be a liquid metal ion source) as well as to appropriate electrodes in the ion beam focusing column 2616 for forming an approximately 1 keV to 60 keV ion beam 2618 and directing the same toward a sample. A deflection controller and amplifier 2636, operated in accordance with a prescribed pattern provided by a pattern generator 2638, can be coupled to the deflection elements 2620 (which can be deflection plates) whereby the focused ion beam 2618 may be controlled manually or automatically to trace out a corresponding pattern on the upper surface of the substrate 2622. In some systems, the deflection elements 2620 can be placed before the final lens. Beam blanking electrodes (not shown) within the ion beam focusing column 2616 can cause the focused ion beam 2618 to impact onto a blanking aperture (not shown) instead of the substrate 2622 when a blanking controller (not shown) applies a blanking voltage to a blanking electrode.

The ion source 2614 can provide a metal ion beam of gallium, for example. In other examples, the ion source 2614 may be a plasma ion source that extracts ions from a generated plasma. The source can be capable of being focused into a sub one-tenth micrometer wide beam at the substrate 2622 for either modifying the substrate 2622 by ion milling, enhanced etch, material deposition, or for the purpose of imaging the substrate 2622.

A charged particle detector 2640, such as an Everhart Thornley or multichannel plate, used for detecting secondary ion or electron emission can be connected to a video circuit 2642 that can supply drive signals to a video monitor 2644 and receive deflection signals from a system controller 2619. The location of the charged particle detector 2640 within the lower chamber 2626 can vary in different embodiments. For example, the charged particle detector 2640 can be coaxial with the ion beam and include a hole for allowing the ion beam to pass. In other embodiments, secondary particles can be collected through a final lens and then diverted off axis for collection.

A micromanipulator 2647 can precisely move objects within the vacuum chamber. The micromanipulator 2647 may comprise precision electric motors 2648 positioned outside the vacuum chamber to provide X, Y, Z, and theta control of a portion 2649 positioned within the vacuum chamber. The micromanipulator 2647 can be fitted with different end effectors for manipulating small objects. In various embodiments described herein, the end effector can be a thin probe 2650.

A gas delivery system 2646 can extend into the lower chamber 2626 for introducing and directing a gaseous vapor toward the substrate 2622. U.S. Pat. No. 5,851,413 to Casella et al. for "Gas Delivery Systems for Particle Beam Processing," assigned to the assignee of the present invention, describes a suitable gas delivery system 2646. Another gas delivery system is described in U.S. Pat. No. 5,435,850 to Rasmussen for a "Gas Injection System," also assigned to the assignee of the present invention. For example, iodine can be delivered to enhance etching, or a metal organic compound can be delivered to deposit a metal.

The system controller 2619 can control the operations of the various parts of the dual beam system 2610. Through the system controller 2619, a user can cause the focused ion beam 2618 or the electron beam 2643 to be scanned in a desired manner through commands entered into any suitable user interface (not shown). Alternatively, the system controller 2619 may control the dual beam system 2610 in accordance with programmed instructions stored in a memory 2621. In various embodiments, any of the one or more software components 311 can be implemented in or otherwise executed by the system controller 2619.

Various embodiments may be a system, a method, an apparatus or a computer program product at any possible technical detail level of integration. The computer program product can include a computer readable storage medium (or media) having computer readable program instructions thereon for causing a processor to carry out aspects of various embodiments. The computer readable storage medium can be a tangible device that can retain and store instructions for use by an instruction execution device. The computer readable storage medium can be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium can also include the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network or a wireless network. The network can comprise copper transmission cables, optical transmission fibers, wireless transmission, routers, firewalls, switches, gateway computers or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of various embodiments can be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions can execute entirely on the user's computer, partly on the user's computer, as a stand-alone software package, partly on the user's computer and partly on a remote computer or entirely on the remote computer or server. In the latter scenario, the remote computer can be connected to the user's computer through any type of network, including a local area network (LAN) or a wide area network (WAN), or the connection can be made to an external computer (for example, through the Internet using an Internet Service Provider). In some embodiments, electronic circuitry including, for example, programmable logic circuitry, field-programmable gate arrays (FPGA), or programmable logic arrays (PLA) can execute the computer readable program instructions by utilizing state information of the computer readable program instructions to personalize the electronic circuitry, in order to perform various aspects.

Various aspects are described herein with reference to flowchart illustrations or block diagrams of methods, apparatus (systems), and computer program products according to various embodiments. It will be understood that each block of the flowchart illustrations or block diagrams, and combinations of blocks in the flowchart illustrations or block diagrams, can be implemented by computer readable program instructions. These computer readable program instructions can be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart or block diagram block or blocks. These computer readable program instructions can also be stored in a computer readable storage medium that can direct a computer, a programmable data processing apparatus, or other devices to function in a particular manner, such that the computer readable storage medium having instructions stored therein comprises an article of manufacture including instructions which implement aspects of the function/act specified in the flowchart or block diagram block or blocks. The computer readable program instructions can also be loaded onto a computer, other programmable data processing apparatus, or other device to cause a series of operational acts to be performed on the computer, other programmable apparatus or other device to produce a computer implemented process, such that the instructions which execute on the computer, other programmable apparatus, or other device implement the functions/acts specified in the flowchart or block diagram block or blocks.

The flowcharts and block diagrams in the Figures illustrate the architecture, functionality, and operation of possible implementations of systems, methods, and computer program products according to various embodiments. In this regard, each block in the flowchart or block diagrams can represent a module, segment, or portion of instructions, which comprises one or more executable instructions for implementing the specified logical function(s). In some alternative implementations, the functions noted in the blocks can occur out of the order noted in the Figures. For example, two blocks shown in succession can, in fact, be executed substantially concurrently, or the blocks can sometimes be executed in the reverse order, depending upon the functionality involved. It will also be noted that each block of the block diagrams or flowchart illustration, and combinations of blocks in the block diagrams or flowchart illustration, can be implemented by special purpose hardware-based systems that perform the specified functions or acts or carry out combinations of special purpose hardware and computer instructions.

While the subject matter has been described above in the general context of computer-executable instructions of a computer program product that runs on a computer or computers, those skilled in the art will recognize that this disclosure also can or can be implemented in combination with other program modules. Generally, program modules include routines, programs, components, data structures, etc. that perform particular tasks or implement particular abstract data types. Moreover, those skilled in the art will appreciate that various aspects can be practiced with other computer system configurations, including single-processor or multiprocessor computer systems, mini-computing devices, mainframe computers, as well as computers, hand-held computing devices (e.g., PDA, phone), microprocessor-based or programmable consumer or industrial electronics, and the like. The illustrated aspects can also be practiced in distributed computing environments in which tasks are performed by remote processing devices that are linked through a communications network. However, some, if not all aspects of this disclosure can be practiced on stand-alone computers. In a distributed computing environment, program modules can be located in both local and remote memory storage devices.

As used in this application, the terms "component," "system," "platform," "interface," and the like, can refer to or can include a computer-related entity or an entity related to an operational machine with one or more specific functionalities. The entities disclosed herein can be either hardware, a combination of hardware and software, software, or software in execution. For example, a component can be, but is not limited to being, a process running on a processor, a processor, an object, an executable, a thread of execution, a program, or a computer. By way of illustration, both an application running on a server and the server can be a component. One or more components can reside within a process or thread of execution and a component can be localized on one computer or distributed between two or more computers. In another example, respective components can execute from various computer readable media having various data structures stored thereon. The components can communicate via local or remote processes such as in accordance with a signal having one or more data packets (e.g., data from one component interacting with another component in a local system, distributed system, or across a network such as the Internet with other systems via the signal). As another example, a component can be an apparatus with specific functionality provided by mechanical parts operated by electric or electronic circuitry, which is operated by a software or firmware application executed by a processor. In such a case, the processor can be internal or external to the apparatus and can execute at least a part of the software or firmware application. As yet another example, a component can be an apparatus that provides specific functionality through electronic components without mechanical parts, wherein the electronic components can include a processor or other means to execute software or firmware that confers at least in part the functionality of the electronic components. In an aspect, a component can emulate an electronic component via a virtual machine, e.g., within a cloud computing system.

In addition, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. As used herein, the term "and/or" is intended to have the same meaning as "or." Moreover, articles "a" and "an" as used in the subject specification and annexed drawings should generally be construed to mean "one or more" unless specified otherwise or clear from context to be directed to a singular form. As used herein, the terms "example" or "exemplary" are utilized to mean serving as an example, instance, or illustration. For the avoidance of doubt, the subject matter disclosed herein is not limited by such examples. In addition, any aspect or design described herein as an "example" or "exemplary" is not necessarily to be construed as preferred or advantageous over other aspects or designs, nor is it meant to preclude equivalent exemplary structures and techniques known to those of ordinary skill in the art.

The herein disclosure describes non-limiting examples. For ease of description or explanation, various portions of the herein disclosure utilize the term "each," "every," or "all" when discussing various examples. Such usages of the term "each," "every," or "all" are non-limiting. In other words, when the herein disclosure provides a description that is applied to "each," "every," or "all" of some particular object or component, it should be understood that this is a non-limiting example, and it should be further understood that, in various other examples, it can be the case that such description applies to fewer than "each," "every," or "all" of that particular object or component.

As it is employed in the subject specification, the term "processor" can refer to substantially any computing processing unit or device comprising, but not limited to, single-core processors; single-processors with software multithread execution capability; multi-core processors; multi-core processors with software multithread execution capability; multi-core processors with hardware multithread technology; parallel platforms; and parallel platforms with distributed shared memory. Additionally, a processor can refer to an integrated circuit, an application specific integrated circuit (ASIC), a digital signal processor (DSP), a field programmable gate array (FPGA), a programmable logic controller (PLC), a complex programmable logic device (CPLD), a discrete gate or transistor logic, discrete hardware components, or any combination thereof designed to perform the functions described herein. Further, processors can exploit nanoscale architectures such as, but not limited to, molecular and quantum-dot based transistors, switches and gates, in order to optimize space usage or enhance performance of user equipment. A processor can also be implemented as a combination of computing processing units. In this disclosure, terms such as "store," "storage," "data store," data storage," "database," and substantially any other information storage component relevant to operation and functionality of a component are utilized to refer to "memory components," entities embodied in a "memory," or components comprising a memory. It is to be appreciated that memory or memory components described herein can be either volatile memory or non-

volatile memory, or can include both volatile and nonvolatile memory. By way of illustration, and not limitation, nonvolatile memory can include read only memory (ROM), programmable ROM (PROM), electrically programmable ROM (EPROM), electrically erasable ROM (EEPROM), flash memory, or nonvolatile random access memory (RAM) (e.g., ferroelectric RAM (FeRAM). Volatile memory can include RAM, which can act as external cache memory, for example. By way of illustration and not limitation, RAM is available in many forms such as synchronous RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), direct Rambus RAM (DRRAM), direct Rambus dynamic RAM (DRDRAM), and Rambus dynamic RAM (RDRAM). Additionally, the disclosed memory components of systems or computer-implemented methods herein are intended to include, without being limited to including, these and any other suitable types of memory.

What has been described above include mere examples of systems and computer-implemented methods. It is, of course, not possible to describe every conceivable combination of components or computer-implemented methods for purposes of describing this disclosure, but many further combinations and permutations of this disclosure are possible. Furthermore, to the extent that the terms "includes," "has," "possesses," and the like are used in the detailed description, claims, appendices and drawings such terms are intended to be inclusive in a manner similar to the term "comprising" as "comprising" is interpreted when employed as a transitional word in a claim.

The descriptions of the various embodiments have been presented for purposes of illustration, but are not intended to be exhaustive or limited to the embodiments disclosed. Many modifications and variations will be apparent without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

Various non-limiting aspects are described in the following examples.

EXAMPLE 1: A system can comprise: a processor that can execute computer-executable components stored in a non-transitory computer-readable memory, wherein the computer-executable components can comprise: an access component that can access a charged-particle microscope that is loaded with a specimen; and an aggregation component that can generate an aggregated image of the specimen, based on a plurality of images of the specimen that are captured by the charged-particle microscope according to a target scanning direction and a plurality of rotated scanning directions.

EXAMPLE 2: The system of any preceding example can be implemented, wherein the plurality of rotated scanning directions and the target scanning direction can be uniformly distributed within a 360-degree range.

EXAMPLE 3: The system of any preceding example can be implemented, wherein the plurality of rotated scanning directions and the target scanning direction can collectively have an even cardinality, such that, for each first scanning direction, there can be a second scanning direction that points 180 degrees away from the first scanning direction.

EXAMPLE 4: The system of any preceding example can be implemented, wherein a target image of the plurality of images can be captured according to the target scanning direction and can have a target field of view of the specimen, and wherein remaining images of the plurality of images can have respectively resized fields of view that circumscribe the target field of view.

EXAMPLE 5: The system of any preceding example can be implemented, wherein the computer-executable components can further comprise: an alignment component that can respectively correctively-rotate the plurality of images according to the plurality of rotated scanning directions, thereby yielding a plurality of aligned images that are aligned with the target field of view.

EXAMPLE 6: The system of any preceding example can be implemented, wherein the alignment component can respectively apply drift-correction to the plurality of aligned images.

EXAMPLE 7: The system of any preceding example can be implemented, wherein the computer-executable components can further comprise: a crop component that can respectively crop, after drift-correction and out of the plurality of aligned images, any pixels or voxels that are not present in the target field of view, thereby yielding a plurality of cropped images each having the same size as the target image.

EXAMPLE 8: The system of any preceding example can be implemented, wherein the aggregation component can average the plurality of cropped images and the target image together, thereby yielding the aggregated image.

EXAMPLE 9: The system of any preceding example can be implemented, wherein the specimen can charge non-homogeneously during scanning, wherein each of the plurality of images can exhibit respective charging artifacts, and wherein the aggregated image can exhibit suppressed charging artifacts.

In various embodiments, any combination or combinations of examples 1-9 can be implemented.

EXAMPLE 10: A computer-implemented method can comprise: accessing, by a device operatively coupled to a processor, a charged-particle microscope that is loaded with a specimen; and generating, by the device, an aggregated image of the specimen, based on a plurality of images of the specimen that are captured by the charged-particle microscope according to a target scanning direction and a plurality of rotated scanning directions.

EXAMPLE 11: The computer-implemented method of any preceding example can be implemented, wherein the plurality of rotated scanning directions and the target scanning direction can be uniformly distributed within a 360-degree range.

EXAMPLE 12: The computer-implemented method of any preceding example can be implemented, wherein the plurality of rotated scanning directions and the target scanning direction can collectively have an even cardinality, such that, for each first scanning direction, there can be a second scanning direction that points 180 degrees away from the first scanning direction.

EXAMPLE 13: The computer-implemented method of any preceding example can be implemented, wherein a target image of the plurality of images can be captured according to the target scanning direction and can have a target field of view of the specimen, and wherein remaining images of the plurality of images can have respectively resized fields of view that circumscribe the target field of view.

EXAMPLE 14: The computer-implemented method of any preceding example can be implemented, further comprising: respectively correctively-rotating, by the device, the plurality of images according to the plurality of rotated scanning directions, thereby yielding a plurality of aligned images that are aligned with the target field of view.

EXAMPLE 15: The computer-implemented method of any preceding example can be implemented, further comprising: respectively applying, by the device, drift-correction to the plurality of aligned images.

EXAMPLE 16: The computer-implemented method of any preceding example can be implemented, further comprising: respectively cropping, by the device and out of the plurality of aligned images, any pixels or voxels that are not present in the target field of view, thereby yielding a plurality of cropped images each having the same size as the target image.

EXAMPLE 17: The computer-implemented method of any preceding example can be implemented, further comprising: averaging, by the device, the plurality of cropped images and the target image together, thereby yielding the aggregated image.

EXAMPLE 18: The computer-implemented method of any preceding example can be implemented, wherein the specimen can charge non-homogeneously during scanning, wherein each of the plurality of images can exhibit respective charging artifacts, and wherein the aggregated image can exhibit suppressed charging artifacts.

In various embodiments, any combination or combinations of examples 10-18 can be implemented.

EXAMPLE 19: A computer program product for facilitating charging artifact mitigation via scanning direction rotation can comprise a non-transitory computer-readable memory having program instructions embodied therewith. In various aspects, the program instructions can be executable by a processor to cause the processor to: access a scanning electron microscope that is loaded with a specimen; cause the scanning electron microscope to respectively capture a plurality of images of the specimen according to a target scanning direction and a plurality of rotated scanning directions, wherein the plurality of images can exhibit respective charging artifacts; correctively-rotate those of the plurality of images that are captured according to the plurality of rotated scanning directions, such that the plurality of images can be aligned with the target scanning direction; and average, after corrective-rotation, the plurality of images, thereby yielding an aggregated image of the specimen, wherein a visibility of charging artifacts in the aggregated image can be lesser than respective visibilities of charging artifacts in the plurality of images.

EXAMPLE 20: The computer program product of any preceding example can be implemented, wherein the target scanning direction and the plurality of rotated scanning directions can be uniformly distributed within a 360-degree range.

In various embodiments, any combination or combinations of examples 19-20 can be implemented.

In various embodiments, any combination or combinations of examples 1-20 can be implemented.


**Claims**

1.  A computer-implemented method, comprising:

    accessing, by a device operatively coupled to a processor, a charged-particle microscope that is loaded with a specimen; and
    generating, by the device, an aggregated image of the specimen, based on a plurality of images of the specimen that are captured by the charged-particle microscope according to a target scanning direction and a plurality of rotated scanning directions.

2.  The computer-implemented method of claim 1, wherein the plurality of rotated scanning directions and the target scanning direction are uniformly distributed within a 360-degree range.

3.  The computer-implemented method of claim 2, wherein the plurality of rotated scanning directions and the target scanning direction collectively have an even cardinality, such that, for each first scanning direction, there is a second scanning direction that points 180 degrees away from the first scanning direction.

4.  The computer-implemented method of any preceding claim, wherein a target image of the plurality of images is captured according to the target scanning direction and has a target field of view of the specimen, and wherein remaining images of the plurality of images have respectively resized fields of view that circumscribe the target field of view.

5.  The computer-implemented method of claim 4, further comprising:
    respectively correctively-rotating, by the device, the plurality of images according to the plurality of rotated scanning directions, thereby yielding a plurality of aligned images that are aligned with the target field of view.

6.  The computer-implemented method of claim 5, further comprising:
    respectively applying, by the device, drift-correction to the plurality of aligned images.

7.  The computer-implemented method of claim 6, further comprising:
    respectively cropping, by the device and out of the plurality of aligned images, any pixels or voxels that are not present in the target field of view, thereby yielding a plurality of cropped images each having the same size as the target image.

8.  The computer-implemented method of claim 7, further comprising:
    averaging, by the device, the plurality of cropped images and the target image together, thereby yielding the aggregated image.

9.  The computer-implemented method of any preceding claim, wherein the specimen charges non-homogeneously during scanning, wherein each of the plurality of images exhibits respective charging artifacts, and wherein the aggregated image exhibits suppressed charging artifacts.

10.  The computer implemented method of any preceding claim, in which the step of accessing a charged particle microscope comprises accessing a scanning electron microscope, the plurality of images of the specimen captured thereby exhibiting respective charging artefacts.

11.  A computer program comprising program code which, when executed by a processor, carries out the method steps of any one of claims 1-10.

12.  A system comprising

    a memory within which is stored the computer program of claim 11; and
    a processor configured to execute the program code of the computer program stored in the memory.

SCIENTIFIC INSTRUMENT MODULE
102

FIRST (MICROSCOPE
ACCESS) LOGIC
104

SECOND (CHARGING-
MITIGATED IMAGE
GENERATION) LOGIC 106

**FIG. 1**

200

PERFORM FIRST OPERATIONS ACCESSING A
CHARGED-PARTICLE MICROSCOPE THAT IS
LOADED WITH A SPECIMEN

202

PERFORM SECOND OPERATIONS GENERATING
AN AGGREGATED IMAGE OF THE SPECIMEN,
BASED ON A PLURALITY OF IMAGES OF THE
SPECIMEN THAT ARE CAPTURED BY THE
CHARGED-PARTICLE MICROSCOPE ACCORDING
TO A TARGET SCANNING DIRECTION AND A
PLURALITY OF ROTATED SCANNING DIRECTIONS

204

**FIG. 2**

**SYSTEM 306**

**SOFTWARE COMPONENTS 311**

AGGREGATION COMPONENT 320

CROP COMPONENT 318

ALIGNMENT COMPONENT 316

SCANNING COMPONENT 314

ACCESS COMPONENT 312

PROCESSOR 308

MEMORY 310

CHARGED-PARTICLE MICROSCOPE 302

SPECIMEN 304

TARGET SCANNING DIRECTION 322

**FIG. 3**

**SYSTEM 306**

**SOFTWARE COMPONENTS 311**

CROP COMPONENT
318

AGGREGATION
COMPONENT 320

SCANNING
COMPONENT 314

ROTATED SCANNING
DIRECTIONS 402

CAPTURED IMAGES
404

ALIGNMENT
COMPONENT 316

ACCESS
COMPONENT 312

PROCESSOR 308

MEMORY 310

CHARGED-PARTICLE
MICROSCOPE 302

SPECIMEN 304

TARGET SCANNING
DIRECTION 322

**FIG. 4**

FIG. 5

EP 4 672 296 A2

FIG. 6

FIG. 7

FIG. 8

EP 4 672 296 A2

SYSTEM 306

SOFTWARE COMPONENTS 311

AGGREGATION COMPONENT 320

CROP COMPONENT 318

ALIGNMENT COMPONENT 316

FIRST EDITED IMAGES 902

SCANNING COMPONENT 314

ROTATED SCANNING DIRECTIONS 402

CAPTURED IMAGES 404

ACCESS COMPONENT 312

CHARGED-PARTICLE MICROSCOPE 302

SPECIMEN 304

TARGET SCANNING DIRECTION 322

PROCESSOR 308

MEMORY 310

**FIG. 9**

404

902

TARGET IMAGE 502 → NO CHANGE → TARGET IMAGE 502

ROTATED IMAGE 506(1) → CORRECTIVELY-ROTATE BY ANGULAR DISPLACEMENT BETWEEN TARGET SCANNING DIRECTION 322 AND ROTATED SCANNING DIRECTION 402(1), POSSIBLY WITH DRIFT-CORRECTION → ALIGNED IMAGE 1002(1)

ROTATED IMAGE 506(N) → CORRECTIVELY-ROTATE BY ANGULAR DISPLACEMENT BETWEEN TARGET SCANNING DIRECTION 322 AND ROTATED SCANNING DIRECTION 402(N), POSSIBLY WITH DRIFT-CORRECTION → ALIGNED IMAGE 1002(N)

506

1002

EP 4 672 296 A2

**FIG. 10**

CORRECTIVELY-ROTATE OR REGISTER BY ϴ TO ALIGN VISUAL CONTENT WITH THAT OF TARGET IMAGE 502

SPECIMEN 304

**FIG. 11**

EP 4 672 296 A2

**FIG. 12**

EP 4 672 296 A2

EP 4 672 296 A2

## SYSTEM 306

### SOFTWARE COMPONENTS 311

**CROP COMPONENT 318**

SECOND EDITED IMAGES 1302

**AGGREGATION COMPONENT 320**

**SCANNING COMPONENT 314**

ROTATED SCANNING DIRECTIONS 402

CAPTURED IMAGES 404

**ALIGNMENT COMPONENT 316**

FIRST EDITED IMAGES 902

**ACCESS COMPONENT 312**

PROCESSOR 308

MEMORY 310

CHARGED-PARTICLE MICROSCOPE 302

SPECIMEN 304

TARGET SCANNING DIRECTION 322

# FIG. 13

EP 4 672 296 A2

902

1302

NO CHANGE

TARGET IMAGE 502 → TARGET IMAGE 502

REMOVE FROM ALIGNED IMAGE 1002(1)
WHICHEVER PIXELS OR VOXELS THAT
ARE NOT IN TARGET IMAGE 502

ALIGNED IMAGE
1002(1) → CROPPED IMAGE
1402(1)

REMOVE FROM ALIGNED IMAGE 1002(N)
WHICHEVER PIXELS OR VOXELS THAT
ARE NOT IN TARGET IMAGE 502

ALIGNED IMAGE
1002(N) → CROPPED IMAGE
1402(N)

1002

1402

**FIG. 14**

FIG. 15

SPECIMEN 304

702

1202

1502

602

A

B

**FIG. 16**

FIG. 17

FIG. 18

FIG. 19

2000

(b)

FIG. 20

— 2100

DISPLAY REGION 2102

DATA ANALYSIS REGION 2104

SCIENTIFIC INSTRUMENT CONTROL REGION 2106

SETTING REGION 2108

FIG. 21

COMPUTING DEVICE 2200

| PROCESSING DEVICE 2202 | BATTERY/POWER 2208 |

| STORAGE DEVICE 2204 | DISPLAY DEVICE 2210 |

| INTERFACE DEVICE 2206 | OTHER I/O DEVICES 2212 |

**FIG. 22**

**FIG. 23**

2400

2402

PROCESSING UNIT — 2404

2408

2406

SYSTEM MEMORY

2412

RAM

2410

ROM

2424

INTERFACE

2426

INTERFACE

2428

INTERFACE

2448

VIDEO ADAPTOR

BUS

2430
OPERATING SYSTEM

2432
APPLICATIONS

2434
MODULES

2436
DATA

2414
HDD

2416
EXTERNAL STORAGE

2420
DRIVE

2422
DISK

2446
MONITOR

2438
KEYBOARD

2440
TOUCH SCREEN

(WIRED/WIRELESS)

2444
INPUT DEVICE INTERFACE

2458
NETWORK ADAPTOR

2442
MOUSE

2460
MODEM

2456
WAN

2450
REMOTE COMPUTER(S)

2454
LAN

2452
MEMORY/ STORAGE

(WIRED/WIRELESS)

FIG. 24

2500

2510

CLIENT(S)

2530

SERVER(S)

CLIENT
DATA
STORE(S)

2520

SERVER
DATA
STORE(S)

2540

COMMUNICATION
FRAMEWORK

2550

FIG. 25

FIG. 26

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 73299924
- US 5851413 A, Casella
- US 5435850 A, Rasmussen